# EUROPEAN PATENT APPLICATION

(11) **EP 4 738 700 A1**
(43) Date of publication of application: **06.05.2026**
(21) Application number: 24844343.4
(22) Date of filing: 16.05.2024
(51) Int. Cl.: H03F 1/02

(54) **POWER AMPLIFICATION SYSTEM, RADIO-FREQUENCY TRANSMISSION SYSTEM AND SIGNAL TRANSMISSION APPARATUS**

(30) Priority: 27.07.2023 CN 202310940369
(71) Applicant: Huawei Technologies Co., Ltd., Shenzhen, Guangdong 518129 (CN)
(72) Inventor: SUO, Hailei, Shenzhen, Guangdong 518129 (CN); ZENG, Zhixiong, Shenzhen, Guangdong 518129 (CN); CHEN, Conghong, Shenzhen, Guangdong 518129 (CN); CHEN, Dong, Shenzhen, Guangdong 518129 (CN)
(74) Representative: Isarpatent
(86) International application number: PCT/CN2024/093765
(87) International publication number: WO 2025/020647

(57) **Abstract**

Embodiments of this application provide a power amplification system, a radio frequency transmission system, and a signal transmission apparatus. The power amplification system includes a hybrid coupler, a first amplifier, a second amplifier, a first impedance conversion line, and a second impedance conversion line. An output port of the first amplifier is coupled to the hybrid coupler via the first impedance conversion line. An output port of the second amplifier is coupled to the hybrid coupler via the second impedance conversion line. The first amplifier and the second amplifier are configured to output radio frequency signals. The hybrid coupler is configured to: perform impedance conversion with the first impedance conversion line and/or the second impedance conversion line; and output a combined radio frequency signal from a fourth port of the hybrid coupler. The combined radio frequency signal is obtained by combining the plurality of radio frequency signals. In embodiments of this application, the hybrid coupler is combined with a wavelength line serving as an impedance conversion line to implement impedance conversion and load pull, reducing area overheads caused by the wavelength line while reducing power consumption of the power amplification system.

## Description

This application claims priority to Chinese Patent Application No. 202310940369.X, filed with the China National Intellectual Property Administration on July 27, 2023 and entitled "POWER AMPLIFICATION SYSTEM, RADIO FREQUENCY TRANSMISSION SYSTEM, AND SIGNAL TRANSMISSION APPARATUS", which is incorporated herein by reference in its entirety.

### TECHNICAL FIELD

This application relates to the field of wireless communication technologies, and in particular, to a power amplification system, a radio frequency transmission system, and a signal transmission apparatus.

### BACKGROUND

In application of wireless communication technologies, data information is carried in radio frequency signals by using modulation technologies, and the radio frequency signals are transmitted to enable wireless communication between a transmitter side and a receiver side. To ensure communication quality of wireless communication, before the radio frequency signals are transmitted, power amplification typically needs to be performed on the radio frequency signals, where the amplification requires a power amplifier. A constant supply power signal is fed to a power supply port of the power amplifier. After an input port of the power amplifier receives a corresponding radio frequency signal, the power amplifier converts, based on a signal power of an input first radio frequency signal, the supply power signal to output a second radio frequency signal. A signal power of the second radio frequency signal is in a gain amplification relationship with the signal power of the first radio frequency signal. The second radio frequency signal is transmitted as a power-amplified radio frequency signal. However, with development of wireless communication technologies, modulation technologies for radio frequency signals are increasingly complex. In this case, to ensure linearity of the second radio frequency signal, the power amplifier needs to have a specific power back-off amount. As the power back-off amount increases, conversion efficiency of the supply power signal decreases, raising quiescent power consumption of the power amplifier, and causing a huge waste of power.

An improved approach is to use a power amplification system based on a Doherty (Doherty) structure to implement power amplification. The power amplification system includes a plurality of impedance conversion lines and at least two power amplifiers including one main power amplifier and one or more auxiliary power amplifiers. One or more power amplifiers implement power amplification based on the signal power of the input first radio frequency signal. When a plurality of power amplifiers operate, the main power amplifier and the auxiliary power amplifier implement load pull (load pull) via the plurality of impedance conversion lines, to obtain the second radio frequency signal by performing power combination on a plurality of radio frequency signals output by the plurality of power amplifiers. The power amplification system based on the Doherty structure can still have high conversion efficiency and a high power back-off amount when amplifying the first radio frequency signal whose signal power is in a low power operating range. In addition, the power amplification system can maintain low quiescent power consumption. However, the Doherty architecture requires a large quantity of wavelength lines for impedance conversion to combine radio frequency signals, which makes an area of the power amplification system larger. In addition, as a quantity of branches of the power amplifier increases, the quantity of wavelength lines also increases, increasing area overheads.

### SUMMARY

Embodiments of this application provide a power amplification system, a radio frequency transmission system, and a signal transmission apparatus, to reduce a quantity of needed wavelength lines while implementing power combination for a plurality of branches.

To achieve the foregoing objectives, the following technical solutions are used in embodiments of this application.

According to a first aspect, a power amplification system is provided. The power amplification system includes a hybrid coupler, a first amplifier, a second amplifier, a first impedance conversion line, and a second impedance conversion line. An output port of the first amplifier is coupled to the hybrid coupler via the first impedance conversion line. An output port of the second amplifier is coupled to the hybrid coupler via the second impedance conversion line. The first amplifier and the second amplifier are configured to output radio frequency signals. The hybrid coupler is configured to: perform impedance conversion with the first impedance conversion line and/or the second impedance conversion line; and output a combined radio frequency signal from a fourth port of the hybrid coupler. The combined radio frequency signal is obtained by combining the plurality of radio frequency signals.

A conventional Doherty architecture, namely, a two-branch Doherty architecture, needs at least four wavelength lines as impedance conversion lines for impedance conversion and load pull, to implement power combination. As a quantity of branches increases, a quantity of wavelength lines also increases. As a result, area overheads are greatly increased, and application and development of the power amplification system of a structure including a plurality of branches are limited. However, in embodiments of this application, the hybrid coupler is coupled to the first amplifier and the second amplifier, so that impedance conversion and load pull can be achieved while reducing the quantity of wavelength lines used as impedance conversion lines, thereby implementing power combination. Through power combination, the power amplification system can have high back-off conversion efficiency, high full-load conversion efficiency, and low quiescent power consumption. In addition, as the quantity of branches of the power amplification system increases, in one or more two-branch structures in the plurality of branches, impedance conversion and load pull may be achieved through one or more hybrid couplers, to reduce more wavelength lines.

For example, a quantity of reduced wavelength lines may vary based on different disposition manners of the hybrid coupler.

For example, based on different types of amplifiers, a plurality of amplifiers may be classified into one main amplifier and at least one auxiliary amplifier. A minimum operating power of the main amplifier is less than minimum operating powers of all other auxiliary amplifiers. The plurality of auxiliary amplifiers have different minimum operating powers.

In a possible implementation, the fourth port of the hybrid coupler is an output port, and a first port, a second port, and a third port of the hybrid coupler each are coupled to an amplification branch, to implement impedance conversion and load pull in an architecture including a plurality branches.

For example, the power amplification system further includes a third amplifier. The output port of the first amplifier is coupled to the first port of the hybrid coupler via the first impedance conversion line. The output port of the second amplifier is coupled to the second port of the hybrid coupler via the second impedance conversion line. An output port of the third amplifier is coupled to the third port of the hybrid coupler. A conventional three-branch Doherty architecture needs at least six wavelength lines as impedance conversion lines for impedance conversion and load pull, to implement power combination. In embodiments of this application, in the power amplification system of a three-branch structure, wavelength lines in three branches may be reduced by using one hybrid coupler, to reduce area overheads caused by the wavelength lines in the power amplification system. Compared with the conventional three-branch Doherty architecture, in embodiments of this application, based on different types of amplifiers including three branches and different coupling relationships between the amplifiers and the hybrid coupler, one or two wavelength lines may be reduced based on one hybrid coupler.

In some possible implementations, the third port of the hybrid coupler is grounded. The fourth port of the hybrid coupler is an output port. The first port and the second port of the hybrid coupler each are coupled to one branch, or the first port or the second port of the hybrid coupler is coupled to one branch. In this case, a minimum operating power of the first amplifier is less than a minimum operating power of the second amplifier.

For example, when the third port of the hybrid coupler is grounded, the power amplification system further includes the third amplifier. The output port of the first amplifier is coupled to the first port of the hybrid coupler via the first impedance conversion line. The output port of the second amplifier is coupled to the second port of the hybrid coupler via the second impedance conversion line. The output port of the third amplifier is coupled to the fourth port of the hybrid coupler. The minimum operating power of the second amplifier is less than a minimum operating power of the third amplifier. In embodiments of this application, when the third port of the hybrid coupler is grounded, the first port of the hybrid coupler may be coupled to the first amplifier used as a first main amplifier, the second port of the hybrid coupler may be coupled to the second amplifier used as a first auxiliary amplifier, and the fourth port of the hybrid coupler may be coupled to the third amplifier used as a second auxiliary amplifier, so that a quantity of needed wavelength lines can be reduced by using the hybrid coupler while power consumption is reduced based on impedance conversion and load pull.

For example, when the third port of the hybrid coupler is grounded, the power amplification system further includes the third amplifier and a third impedance conversion line. The output port of the first amplifier is coupled to the first port of the hybrid coupler via the first impedance conversion line. The output port of the second amplifier is coupled to the second port of the hybrid coupler via the second impedance conversion line. The output port of the third amplifier is coupled to the fourth port of the hybrid coupler via the third impedance conversion line. A minimum operating power of the third amplifier is less than the minimum operating power of the first amplifier. In embodiments of this application, when the third port of the hybrid coupler is grounded, the first port of the hybrid coupler may be coupled to the first amplifier used as a first auxiliary amplifier, the second port of the hybrid coupler may be coupled to the second amplifier used as a second auxiliary amplifier, and the fourth port of the hybrid coupler may be coupled to the third amplifier used as a first main amplifier, so that a quantity of needed wavelength lines can be reduced by using the hybrid coupler while power consumption is reduced based on impedance conversion and load pull.

For example, when the third port of the hybrid coupler is grounded, the power amplification system further includes the third amplifier, a third impedance conversion line, and a fourth impedance conversion line. The output port of the first amplifier is coupled to the first port of the hybrid coupler via the first impedance conversion line. The output port of the second amplifier is coupled to the first port of the hybrid coupler via the second impedance conversion line and the fourth impedance conversion line that are connected in series. The output port of the third amplifier is coupled to the second port of the hybrid coupler via the third impedance conversion line. A minimum operating power of the third amplifier is less than the minimum operating power of the first amplifier. In embodiments of this application, the third amplifier is a first main amplifier, the first amplifier is a first auxiliary amplifier, and the second amplifier is a second auxiliary amplifier. According to the coupling manner in embodiments of this application, a quantity of needed wavelength lines can be reduced by using the hybrid coupler while power consumption is reduced based on impedance conversion and load pull.

For example, when the third port of the hybrid coupler is grounded, the power amplification system further includes the third amplifier. The output port of the first amplifier is coupled to the first port of the hybrid coupler via the first impedance conversion line. The output port of the third amplifier is coupled to the first port of the hybrid coupler. The output port of the second amplifier is coupled to the second port of the hybrid coupler via the second impedance conversion line. A minimum operating power of the third amplifier is greater than the minimum operating power of the first amplifier and less than the minimum operating power of the second amplifier. In embodiments of this application, the first amplifier is a first main amplifier, the third amplifier is a first auxiliary amplifier, and the second amplifier is a second auxiliary amplifier. According to the coupling manner in embodiments of this application, a quantity of needed wavelength lines can be reduced by using the hybrid coupler while power consumption is reduced based on impedance conversion and load pull.

For example, when the third port of the hybrid coupler is grounded, the power amplification system further includes the third amplifier and a third impedance conversion line. The output port of the first amplifier is coupled to the first port of the hybrid coupler via the first impedance conversion line and the third impedance conversion line that are connected in series. The output port of the third amplifier is coupled to a first port of the third impedance conversion line, and is coupled to the first port of the hybrid coupler via a second port of the third impedance conversion line. The output port of the second amplifier is coupled to the second port of the hybrid coupler via the second impedance conversion line. A minimum operating power of the third amplifier is greater than the minimum operating power of the first amplifier and less than the minimum operating power of the second amplifier. In embodiments of this application, the first amplifier is a first main amplifier, the third amplifier is a first auxiliary amplifier, and the second amplifier is a second auxiliary amplifier. According to the coupling manner in embodiments of this application, a quantity of needed wavelength lines can be reduced by using the hybrid coupler while power consumption is reduced based on impedance conversion and load pull.

In some possible implementations, the third port of the hybrid coupler may not be used. The fourth port of the hybrid coupler is used as an output port. Impedance conversion and load pull are achieved through at least two of the first port, the second port, and the fourth port of the hybrid coupler. In this case, a minimum operating power of the first amplifier is less than a minimum operating power of the second amplifier.

For example, when the third port of the hybrid coupler is not used, the power amplification system further includes the third amplifier and a third impedance conversion line. The output port of the first amplifier is coupled to the first port of the hybrid coupler via the first impedance conversion line. The output port of the second amplifier is coupled to the second port of the hybrid coupler via the second impedance conversion line. A first port of the third impedance conversion line is coupled to the fourth port of the hybrid coupler. The output port of the third amplifier is coupled to a second port of the third impedance conversion line. The minimum operating power of the second amplifier is less than a minimum operating power of the third amplifier. In embodiments of this application, the first amplifier is a first main amplifier, the second amplifier is a first auxiliary amplifier, and the third amplifier is a second auxiliary amplifier. According to the coupling manner in embodiments of this application, a quantity of needed wavelength lines can be reduced by using the hybrid coupler while power consumption is reduced based on impedance conversion and load pull.

For example, when the third port of the hybrid coupler is not used, the power amplification system further includes the third amplifier and a third impedance conversion line. The output port of the first amplifier is coupled to the first port of the hybrid coupler via the first impedance conversion line and the third impedance conversion line that are connected in series. The output port of the second amplifier is coupled to the second port of the hybrid coupler via the second impedance conversion line. The output port of the third amplifier is coupled to a first port of the third impedance conversion line, and is coupled to the first port of the hybrid coupler via a second port of the third impedance conversion line. A minimum operating power of the third amplifier is greater than the minimum operating power of the first amplifier and less than the minimum operating power of the second amplifier. In embodiments of this application, the first amplifier is a first main amplifier, the third amplifier is a first auxiliary amplifier, and the second amplifier is a second auxiliary amplifier. According to the coupling manner in embodiments of this application, a quantity of needed wavelength lines can be reduced by using the hybrid coupler while power consumption is reduced based on impedance conversion and load pull.

For example, when the third port of the hybrid coupler is not used, the power amplification system further includes the third amplifier, a third impedance conversion line, and a fourth impedance conversion line. The output port of the first amplifier is coupled to the first port of the hybrid coupler via the first impedance conversion line. The output port of the second amplifier is coupled to the second port of the hybrid coupler via the second impedance conversion line. A first port of the fourth impedance conversion line is coupled to the fourth port of the hybrid coupler. The output port of the third amplifier is coupled to a second port of the fourth impedance conversion line via the third impedance conversion line. A minimum operating power of the third amplifier is less than the minimum operating power of the first amplifier. In embodiments of this application, the third amplifier is a first main amplifier, the first amplifier is a first auxiliary amplifier, and the second amplifier is a second auxiliary amplifier. According to the coupling manner in embodiments of this application, a quantity of needed wavelength lines can be reduced by using the hybrid coupler while power consumption is reduced based on impedance conversion and load pull.

For example, when the third port of the hybrid coupler is not used, the power amplification system further includes the third amplifier and a third impedance conversion line. The output port of the first amplifier is coupled to the first port of the hybrid coupler via the first impedance conversion line. The output port of the second amplifier is coupled to the first port of the hybrid coupler via the second impedance conversion line and the third impedance conversion line that are connected in series. The output port of the third amplifier is coupled to the second port of the hybrid coupler. The minimum operating power of the second amplifier is less than a minimum operating power of the third amplifier. In embodiments of this application, the first amplifier is a first main amplifier, the second amplifier is a first auxiliary amplifier, and the third amplifier is a second auxiliary amplifier. According to the coupling manner in embodiments of this application, a quantity of needed wavelength lines can be reduced by using the hybrid coupler while power consumption is reduced based on impedance conversion and load pull.

For example, when the third port of the hybrid coupler is not used, the power amplification system further includes the third amplifier and a third impedance conversion line. The output port of the first amplifier is coupled to the first port of the hybrid coupler via the first impedance conversion line. The output port of the second amplifier is coupled to the second port of the hybrid coupler via the second impedance conversion line and the third impedance conversion line that are connected in series. The output port of the third amplifier is coupled to the fourth port of the hybrid coupler. The minimum operating power of the second amplifier is less than a minimum operating power of the third amplifier. In embodiments of this application, the first amplifier is a first main amplifier, the second amplifier is a first auxiliary amplifier, and the third amplifier is a second auxiliary amplifier. According to the coupling manner in embodiments of this application, a quantity of needed wavelength lines can be reduced by using the hybrid coupler while power consumption is reduced based on impedance conversion and load pull.

For example, when the third port of the hybrid coupler is not used, the power amplification system further includes the third amplifier, a third impedance conversion line, and a fourth impedance conversion line. The output port of the first amplifier is coupled to the first port of the hybrid coupler. The output port of the second amplifier is coupled to the second port of the hybrid coupler via the second impedance conversion line and the third impedance conversion line that are connected in series. The output port of the third amplifier is coupled to the fourth port of the hybrid coupler via the fourth impedance conversion line. A minimum operating power of the third amplifier is less than the minimum operating power of the first amplifier. In embodiments of this application, the third amplifier is a first main amplifier, the first amplifier is a first auxiliary amplifier, and the second amplifier is a second auxiliary amplifier. According to the coupling manner in embodiments of this application, a quantity of needed wavelength lines can be reduced by using the hybrid coupler while power consumption is reduced based on impedance conversion and load pull.

For example, when the third port of the hybrid coupler is not used, the power amplification system further includes the third amplifier, a third impedance conversion line, and a fourth impedance conversion line. The output port of the first amplifier is coupled to the first port of the hybrid coupler via the first impedance conversion line. The output port of the second amplifier is coupled to the first port of the hybrid coupler via the second impedance conversion line and the third impedance conversion line that are connected in series. The output port of the third amplifier is coupled to the second port of the hybrid coupler via the fourth impedance conversion line. A minimum operating power of the third amplifier is less than the minimum operating power of the first amplifier. In embodiments of this application, the third amplifier is a first main amplifier, the first amplifier is a first auxiliary amplifier, and the second amplifier is a second auxiliary amplifier. According to the coupling manner in embodiments of this application, a quantity of needed wavelength lines can be reduced by using the hybrid coupler while power consumption is reduced based on impedance conversion and load pull.

In some possible implementations, the second port and the third port of the hybrid coupler may be grounded, or the second port and the third port of the hybrid coupler may not be used. The fourth port of the hybrid coupler is used as an output port. In this case, the power amplification system further includes a third impedance conversion line. A minimum operating power of the first amplifier is less than a minimum operating power of the second amplifier. The output port of the first amplifier is coupled to the first port of the hybrid coupler via the first impedance conversion line. The output port of the second amplifier is coupled to the first port of the hybrid coupler via the second impedance conversion line and the third impedance conversion line that are connected in series. In embodiments of this application, the second port and the third port of the hybrid coupler may be grounded, or the second port and the third port of the hybrid coupler may not be used. In addition, the first port of the hybrid coupler is coupled to two amplification branches, to reduce a quantity of wavelength lines in an architecture including two branches.

For example, when the second port and the third port of the hybrid coupler are grounded, or the second port and the third port of the hybrid coupler are not used, a quantity of wavelength lines in an architecture including three branches can also be reduced by using the hybrid coupler. In this case, the power amplification system further includes the third amplifier. The fourth port of the hybrid coupler is coupled to the output port of the third amplifier. The minimum operating power of the second amplifier is less than a minimum operating power of the third amplifier. In embodiments of this application, the first amplifier is a first main amplifier, the second amplifier is a first auxiliary amplifier, and the third amplifier is a second auxiliary amplifier. According to the coupling manner in embodiments of this application, a quantity of needed wavelength lines can be reduced by using the hybrid coupler while power consumption is reduced based on impedance conversion and load pull.

For example, when the second port and the third port of the hybrid coupler are grounded, or the second port and the third port of the hybrid coupler are not used, a quantity of wavelength lines in an architecture including three branches can also be reduced by using the hybrid coupler. In this case, the power amplification system further includes the third amplifier and a fourth impedance conversion line. The output port of the third amplifier is coupled to the fourth port of the hybrid coupler via the fourth impedance conversion line. A minimum power of the third amplifier is less than the minimum operating power of the first amplifier. In embodiments of this application, the third amplifier is a first main amplifier, the first amplifier is a first auxiliary amplifier, and the second amplifier is a second auxiliary amplifier. According to the coupling manner in embodiments of this application, a quantity of needed wavelength lines can be reduced by using the hybrid coupler while power consumption is reduced based on impedance conversion and load pull.

In some possible implementations, the hybrid coupler is a coupler based on a three-dimensional stacked structure. For example, the hybrid coupler may be a coupler based on a waveguide suspended line process, or a suspended coupler based on a substrate integrated suspended line (Substrate Integrated Suspended Line, SISL) process. In embodiments of this application, a coupler of a three-dimensional stacked structure is used as the hybrid coupler coupler1. Compared with a conventional coupler, the coupler of a three-dimensional stacked structure is formed by using a plurality of stacked structures. This can reduce an area occupied by the coupler.

For example, a frequency band of an input radio frequency signal is 860 MHz. A length of one wavelength line is approximately 52 mm. When the hybrid coupler is a suspended coupler, a length of one hybrid coupler is about 6 mm. Therefore, in embodiments of this application, area overheads caused by a wavelength line in the power amplification system can be greatly reduced.

According to a second aspect, an embodiment of this application further provides a radio frequency transmission system. The radio frequency transmission system includes a radio frequency generation circuit and the power amplification system described in the first aspect. An output port of the radio frequency generation circuit is coupled to an input port of the power amplification system.

According to a third aspect, an embodiment of this application further provides a signal transmission apparatus. The signal transmission apparatus includes a baseband processing system and the radio frequency transmission system described in the second aspect.

For technical principles and beneficial effects of the second aspect and the third aspect, refer to related descriptions of the first aspect. Details are not described herein again.

### BRIEF DESCRIPTION OF DRAWINGS

FIG. 1 is a diagram of a structure of a power amplifier;
FIG. 2 is a diagram of a response relationship between a gain amplification coefficient and an input power of a power amplifier;
FIG. 3 is a diagram of a structure of a signal transmission apparatus according to an embodiment of this application;
FIG. 4 is a diagram of a structure of a radio frequency transmission system according to an embodiment of this application;
FIG. 5 is a diagram 1 of a structure of a first power amplification system according to an embodiment of this application;
FIG. 6 is a diagram 2 of another structure of a first power amplification system according to an embodiment of this application;
FIG. 7 is a diagram of a response relationship between a current of each branch and a power of an input signal of the first power amplification system shown in FIG. 6 according to an embodiment of this application;
FIG. 8 is a diagram of a response relationship between a voltage of each branch and a power of an input signal of the first power amplification system shown in FIG. 6 according to an embodiment of this application;
FIG. 9 is a diagram of a response relationship between an impedance load of each branch and a power of an input signal of the first power amplification system shown in FIG. 6 according to an embodiment of this application;
FIG. 10 is a diagram of a response relationship between conversion efficiency and a power of an input signal of the first power amplification system shown in FIG. 6 according to an embodiment of this application;
FIG. 11 is a diagram 3 of still another structure of a first power amplification system according to an embodiment of this application;
FIG. 12 is a diagram of a response relationship between a current of each branch and a power of an input signal of the first power amplification system shown in FIG. 11 according to an embodiment of this application;
FIG. 13 is a diagram of a response relationship between a voltage of each branch and a power of an input signal of the first power amplification system shown in FIG. 11 according to an embodiment of this application;
FIG. 14 is a diagram of a response relationship between an impedance load of each branch and a power of an input signal of the first power amplification system shown in FIG. 11 according to an embodiment of this application;
FIG. 15 is a diagram of a response relationship between conversion efficiency and a power of an input signal of the first power amplification system shown in FIG. 11 according to an embodiment of this application;
FIG. 16 is a diagram of a structure of a correspondence between ports of a hybrid coupler according to an embodiment of this application;
FIG. 17 is a diagram 1 of a structure of a second power amplification system according to an embodiment of this application;
FIG. 18 is a diagram 2 of another structure of a second power amplification system according to an embodiment of this application;
FIG. 19 is a diagram 3 of still another structure of a second power amplification system according to an embodiment of this application;
FIG. 20 is a diagram 4 of still another structure of a second power amplification system according to an embodiment of this application;
FIG. 21 is a diagram 5 of still another structure of a second power amplification system according to an embodiment of this application;
FIG. 22 is a diagram 6 of still another structure of a second power amplification system according to an embodiment of this application;
FIG. 23 is a diagram 7 of still another structure of a second power amplification system according to an embodiment of this application;
FIG. 24 is a diagram 8 of still another structure of a second power amplification system according to an embodiment of this application;
FIG. 25 is a diagram 9 of still another structure of a second power amplification system according to an embodiment of this application;
FIG. 26 is a diagram 10 of still another structure of a second power amplification system according to an embodiment of this application;
FIG. 27 is a diagram 11 of still another structure of a second power amplification system according to an embodiment of this application;
FIG. 28 is a diagram 12 of still another structure of a second power amplification system according to an embodiment of this application;
FIG. 29 is a diagram 13 of still another structure of a second power amplification system according to an embodiment of this application;
FIG. 30 is a diagram 14 of still another structure of a second power amplification system according to an embodiment of this application;
FIG. 31 is a diagram 15 of still another structure of a second power amplification system according to an embodiment of this application;
FIG. 32 is a diagram 16 of still another structure of a second power amplification system according to an embodiment of this application;
FIG. 33 is a diagram 17 of still another structure of a second power amplification system according to an embodiment of this application;
FIG. 34 is a diagram 18 of still another structure of a second power amplification system according to an embodiment of this application;
FIG. 35 is a diagram of a response relationship between a current of each branch and a power of an input signal of the second power amplification system shown in FIG. 34 according to an embodiment of this application;
FIG. 36 is a diagram of a response relationship between a voltage of each branch and a power of an input signal of the second power amplification system shown in FIG. 34 according to an embodiment of this application;
FIG. 37 is a diagram of a response relationship between an impedance load of each branch and a power of an input signal of the second power amplification system shown in FIG. 34 according to an embodiment of this application;
FIG. 38 is a diagram of a response relationship between conversion efficiency and a power of an input signal of the second power amplification system shown in FIG. 34 according to an embodiment of this application;
FIG. 39 is a diagram 19 of still another structure of a second power amplification system according to an embodiment of this application;
FIG. 40 is a diagram 20 of still another structure of a second power amplification system according to an embodiment of this application;
FIG. 41 is a diagram 21 of still another structure of a second power amplification system according to an embodiment of this application;
FIG. 42 is a diagram of a response relationship between a current of each branch and a power of an input signal of the second power amplification system shown in FIG. 39, FIG. 40, and FIG. 41 according to an embodiment of this application;
FIG. 43 is a diagram of a response relationship between a voltage of each branch and a power of an input signal of the second power amplification system shown in FIG. 39, FIG. 40, and FIG. 41 according to an embodiment of this application;
FIG. 44 is a diagram of a response relationship between an impedance load of each branch and a power of an input signal of the second power amplification system shown in FIG. 39, FIG. 40, and FIG. 41 according to an embodiment of this application; and
FIG. 45 is a diagram of a response relationship between conversion efficiency and a power of an input signal of the second power amplification system shown in FIG. 39, FIG. 40, and FIG. 41 according to an embodiment of this application.

### DESCRIPTION OF EMBODIMENTS

It should be noted that the terms such as "first" and "second" in embodiments of this application are merely used to distinguish between features of a same type, and cannot be understood as an indication of relative importance, a quantity, a sequence, or the like.

The term "example", "for example", or the like in embodiments of this application is used to represent giving an example, an illustration, or a description. Any embodiment or design scheme described as an "example" or "for example" in this application should not be explained as being more preferred or having more advantages than another embodiment or design scheme. To be precise, use of the term "example", "for example", or the like is intended to present a relative concept in a specific manner.

The terms "coupling" and "connection" in embodiments of this application should be understood in a broad sense, for example, may be a physical direct connection, or may be an indirect connection implemented through an electronic component, for example, a connection implemented through a resistor, an inductor, a capacitor, a microstrip, a coupler, or another electronic component.

First, some basic concepts in this application are described.

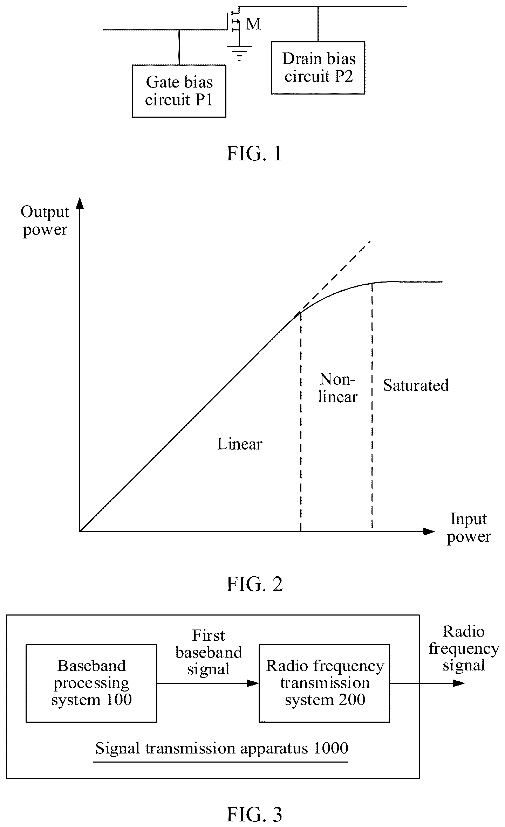

Power amplifier: Power amplifiers may be classified into transistor power-type amplifiers and switching-type power amplifiers. The transistor power-type amplifiers may be further classified into class-A power amplifiers, class-B power amplifiers, class-AB power amplifiers, and class-C power amplifiers. The class A power amplifier, the class B power amplifier, and the class AB power amplifier are linear power amplifiers. The class C power amplifier is a non-linear power amplifier. The class A power amplifier can operate in a full-cycle mode, exhibits optimal linearity, and is suitable for power amplification on a small direct current signal. The class B power amplifier can operate in a half-cycle mode, and the single-ended class B power amplifier produces significant non-linear distortion. The class AB power amplifier is a combination of the class A power amplifier and the class B power amplifier. Efficiency and linearity of the class AB power amplifier are between the class A power amplifier and the class B power amplifier, and the class AB power amplifier is widely used in power amplification of radio frequency signals. The class C power amplifier is a non-linear power amplifier. FIG. 1 shows a basic structure of a single transistor power-type amplifier. In the figure, a gate bias circuit P1 is disposed at a gate of a power transistor M, and a drain bias circuit P2 is disposed at a drain of the power transistor M. A bias state between electrodes of the power transistor M is controlled through the gate bias circuit P1 and the drain bias circuit P2, so that the power transistor M is in a power amplification state. The power transistor M in the power amplification state may perform power amplification on a received signal.

Efficiency (efficiency) of a power amplifier refers to a percentage of an input power that can be converted into a useful output power. In actual application, a ratio of a power of a signal output by the power amplifier to a power supplied by a power supply is the efficiency of the power amplifier, denoted as η, that is, η=Po/PE* 100%. According to the definition, efficiency of the power amplifier=(output power/supplied power)×100%. FIG. 1 is used as an example, operating efficiency of the power amplifier may be reflected by operating efficiency of the drain bias circuit P2 provided by the power transistor M, that is, a rate at which a drain direct-current signal provided by the drain bias circuit P2 is converted into a radio frequency signal actually output by the power amplifier. The operating efficiency of the power amplifier decreases with the output power. The output power of the power amplifier is positively correlated with an input power of the power amplifier. The input power of the power amplifier is a power of a radio frequency signal received by the gate of the power transistor M shown in FIG. 1.

Power back-off of the power amplifier: FIG. 2 is a diagram of power amplification of a single power amplifier. It can be learned that the power amplifier has a linear operating power range. In the linear operating power range, an amplification gain between the input power and the output power of the power amplifier is linear (that is, a proportional constant amplification gain factor). When the input power of the power amplifier exceeds the linear operating power range, the amplification gain between the input power and the output power is non-linear. Even when the input power is in a saturation power range of the power amplifier, the output power no longer increases with the input power. To ensure that the radio frequency signal output by the power amplifier is linearly amplified, power back-off needs to be performed on the power amplifier (that is, a specific amount of power needs to be backed off from a maximum operating power point of power amplification). The radio frequency signal received by the power amplifier is a modulated signal obtained by modulating data information onto a carrier signal. A power back-off amount is related to a peak to average power ratio (peak to average power ratio, PAPR) of the modulated signal. In wireless communication, a radio frequency signal is used to carry a data signal that needs to be communicated. A larger amount of data carried on the radio frequency signal indicates a higher power of the radio frequency signal received by the power transistor M.

A quiescent current is a current on an electronic component when there is no external signal input, that is, a current consumed by the electronic component without being affected by external factors. Similarly, a quiescent voltage is a voltage on the electronic component when there is no external signal input, that is, a holdover voltage of the electronic component without being affected by external factors. Quiescent power consumption is power consumption of the electronic component in a quiescent current state and/or a quiescent voltage state.

Embodiments of this application further provide a signal transmission apparatus. As shown in FIG. 3, the signal transmission apparatus 1000 includes a baseband processing system 100 and a radio frequency transmission system 200. An output port of the baseband processing system 100 is coupled to an input port of the radio frequency transmission system 200. The baseband processing system 100 is configured to: send data information to the radio frequency transmission system 200 in a form of a first baseband signal. The radio frequency transmission system 200 is configured to: use a radio frequency signal to carry the first baseband signal based on a modulation technology, and transmit the radio frequency signal to implement wireless communication.

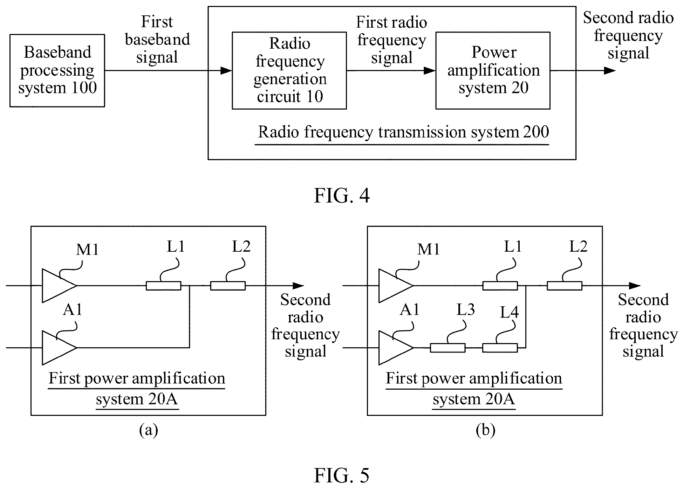

As shown in FIG. 4, the radio frequency transmission system 200 includes a radio frequency generation circuit 10 and a power amplification system 20. An output port of the radio frequency generation circuit 10 is coupled to an input port of the power amplification system 20. The radio frequency generation circuit 10 is configured to: use a first radio frequency signal to carry the first baseband signal based on a modulation technology, and output the first radio frequency signal to the power amplification system 20.

For example, the power amplification system 20 may include one or more input ports. In some examples, the radio frequency generation circuit 10 may output one or more first radio frequency signals to one input port of the power amplification system 20. In some examples, the radio frequency generation circuit 10 may output one or more first radio frequency signals to a plurality of input ports of the power amplification system 20. In some examples, the plurality of first radio frequency signals may be a same radio frequency signal, or may be different radio frequency signals.

In some possible implementations, the power amplification system 20 shown in FIG. 4 is a first power amplification system based on a Doherty (Doherty) architecture. The first power amplification system includes a plurality of power amplifiers. One of the plurality of power amplifiers is a main power amplifier (main power amplifier, MPA), also referred to as a carrier power amplifier (carrier power amplifier, CPA). The main power amplifier may be a class AB power amplifier. The other one or more power amplifiers in the plurality of power amplifiers are auxiliary power amplifiers (auxiliary power amplifiers, APAs), also referred to as peak power amplifiers (peak power amplifiers, PPAs). The auxiliary power amplifier may be a class B power amplifier or a class C power amplifier. For example, the first power amplification system may be based on a conventional two-branch Doherty architecture and a conventional multi-branch Doherty architecture.

In some examples, as shown in (a) in FIG. 5, a first power amplification system 20A is of a conventional Doherty architecture including one main amplifier M1 and one first auxiliary amplifier A1. In this case, the first power amplification system 20A further includes a first wavelength line L1 and a second wavelength line L2. An output port of the first main amplifier M1 is coupled to a first port of the first wavelength line L1, and is coupled to a first port of the second wavelength line L2 via a second port of the first wavelength line L1. An output port of the first auxiliary amplifier A1 is coupled to the second port of the first wavelength line L1. In embodiments of this application, a minimum operating power of the first auxiliary amplifier A1 is greater than a minimum operating power of the first main amplifier M1. When an operating power of the first power amplification system 20A is in a low power operating range, the first auxiliary amplifier A1 does not operate, and the first main amplifier M1 is enabled to operate. In this way, when a power of an input radio frequency signal is low, the first main amplifier M1 may operate in a high power operating range, to implement high back-off conversion efficiency. When a power of an input radio frequency signal is high, the first power amplification system 20A operates in a high power operating range, and both the first main amplifier M1 and the first auxiliary amplifier A1 operate. In this case, the first main amplifier M1 and the first auxiliary amplifier A1 respectively output the two power-amplified radio frequency signals after performing power amplification on input radio frequency signals. When the first power amplification system 20A operates in the high power operating range, impedance inversion (impedance inversion) may be performed based on the first wavelength line L1. Due to the impedance inversion based on the first wavelength line L1, when the first auxiliary amplifier A1 is enabled to operate, a power of a branch in which the first main amplifier M1 is located may continue to increase. Based on variations in an operating voltage, an operating current, and a load size of branches in which the first main amplifier M1 and the first auxiliary amplifier A1 are located during the impedance inversion based on the first wavelength line L1, with reference to output impedance matching via the second wavelength line L2, the first power amplification system 20A may implement load pull (loud pull), to obtain a second radio frequency signal by performing power combination on the radio frequency signals output by the first main amplifier M1 and the first auxiliary amplifier A1. When both the first main amplifier M1 and the first auxiliary amplifier A1 in the first power amplification system 20A operate, the first power amplification system 20A can also maintain high full-load conversion efficiency. In addition, when the first power amplification system 20A is in an idle state, the first main amplifier M1 may be biased at a low quiescent operating voltage and/or a low quiescent operating current, and therefore has low quiescent power consumption. However, in actual application, the Doherty architecture shown in (a) in FIG. 5 is merely a theoretical architecture based on load pull and impedance conversion. In actual application, the structure further includes many wavelength lines that do not undergo impedance inversion. These wavelength lines are connected in series in pairs. Two wavelength lines that are connected in series as impedance conversion lines may compensate for each other's impedance inversion effects, and therefore are not shown in the theoretical diagram in (a) in FIG. 5. However, in actual application, these wavelength lines used as impedance conversion lines are still needed to implement power combination on a plurality of radio frequency signals. For example, as shown in (b) in FIG. 5, the first power amplification system 20A based on the structure shown in (a) in FIG. 5 further includes a third wavelength line L3 and a fourth wavelength line L4. After being coupled to the third wavelength line L3 and the fourth wavelength line L4, the output port of the first auxiliary amplifier A1 is coupled to the second port of the first wavelength line L1 via the fourth wavelength line L4. As shown in (b) in FIG. 5, a conventional Doherty architecture needs at least four impedance conversion lines (for example, the first wavelength line L1, the second wavelength line L2, the third wavelength line L3, and the fourth wavelength line L4) for power combination. However, in an actual product, area overheads of the power transistor M and the like used by the power amplifier are low. A wavelength line serving as an impedance conversion line is usually a 1/4 wavelength of a radio frequency signal, and has a specific length and area. A large quantity of wavelength lines increase an area of the first power amplification system 20A. Using a frequency band less than 1 GHz as an example, a length of a wavelength line corresponding to an 860 MHz radio frequency signal is approximately 52 millimeters (mm). Therefore, main area overheads of the first power amplification system 20A are caused by the wavelength lines, and greatly increase with a quantity of branches in the Doherty architecture. The following uses the multi-branch Doherty architecture as an example.

In some examples, the first power amplification system 20A may alternatively be of a multi-branch Doherty architecture including a plurality of amplifiers. For example, the multi-branch Doherty architecture includes three amplifiers: a first main amplifier, a first auxiliary amplifier, and a second auxiliary amplifier, which are sorted in ascending order of minimum operating powers. When the first power amplification system 20A is in a low power operating range, the first main amplifier is enabled to operate, and the two auxiliary amplifiers do not operate. When the first power amplification system 20A is in a medium power operating range, the first main amplifier and the first auxiliary amplifier are enabled to operate, and the second auxiliary amplifier does not operate. When the first power amplification system 20A is in a high power operating range, the first main amplifier, the first auxiliary amplifier, and the second auxiliary amplifier are all enabled to operate.

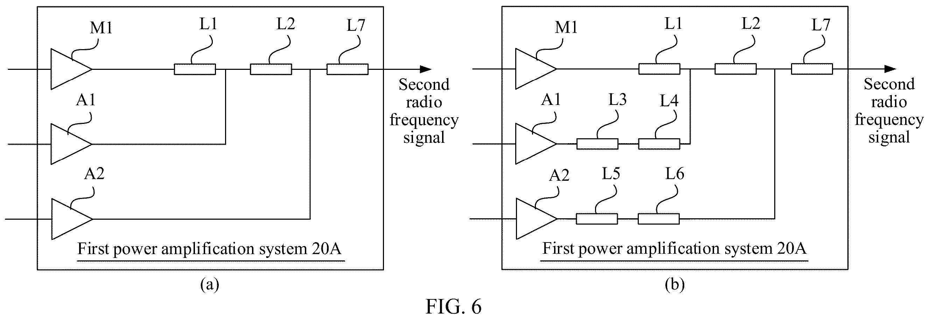

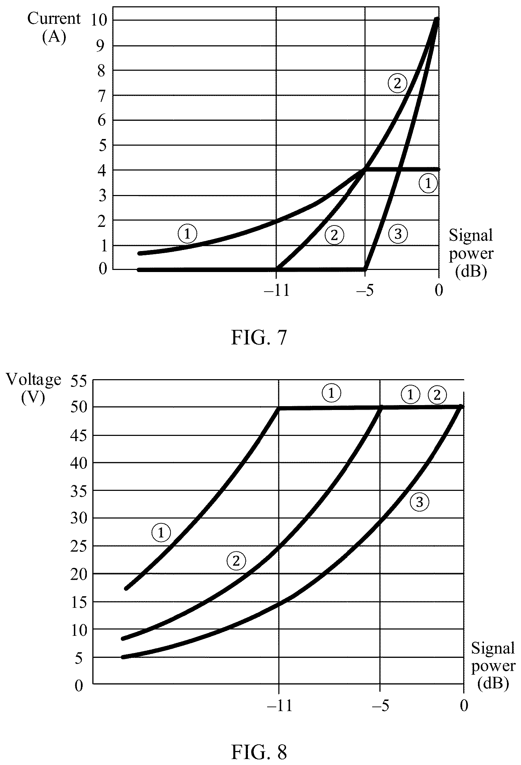

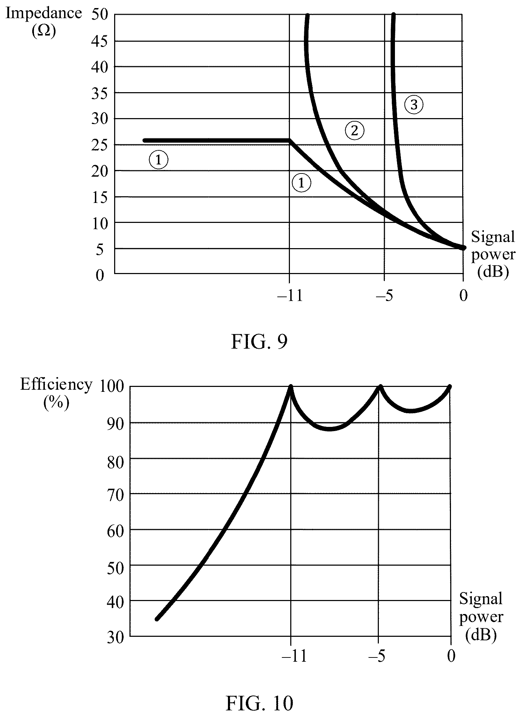

For example, when the first power amplification system 20A is based on a Doherty architecture including three branches, as shown in (a) in FIG. 6, the first power amplification system 20A includes a first main amplifier M1, a first auxiliary amplifier A1, a second auxiliary amplifier A2, a first wavelength line L1, a second wavelength line L2, and a seventh wavelength line L7. An output port of the first main amplifier M1 is coupled to a first port of the first wavelength line L1, and a second port of the first wavelength line L1 is coupled to a first port of the second wavelength line L2. A second port of the second wavelength line L2 is coupled to a first port of the seventh wavelength line L7. An output port of the first auxiliary amplifier A1 is coupled to the second port of the first wavelength line L1, and an output port of the second auxiliary amplifier A2 is coupled to the second port of the second wavelength line L2. A second port of the seventh wavelength line L7 is configured to output a second radio frequency signal obtained through power combination. FIG. 7, FIG. 8, FIG. 9, and FIG. 10 each are a diagram of a change curve of a circuit parameter and a power of an input radio frequency signal of the first power amplification system 20A shown in (a) in FIG. 6. FIG. 7 is a diagram of a change curve of a current of each branch and a power of an input radio frequency signal. FIG. 8 is a diagram of a change curve of a voltage of each branch and a power of an input radio frequency signal. FIG. 9 is a diagram of a change curve of a load impedance of each branch and a power of an input radio frequency signal. FIG. 10 is a diagram of a change curve of conversion efficiency and a power of an input radio frequency signal of the first power amplification system 20A. In the figures, a line ① represents a branch in which the first main amplifier M1 is located, a line ② represents a branch in which the first auxiliary amplifier A1 is located, and a line ③ represents a branch in which the second auxiliary amplifier A2 is located. For example, 0 dB is a maximum operating power point of the first power amplification system 20A.

When the signal power of the input radio frequency signal is below -11 dB, the first power amplification system 20A shown in (a) in FIG. 6 is in the low power operating range. In this case, the first main amplifier M1 operates, and the first auxiliary amplifier A1 and the second auxiliary amplifier A2 do not operate. In the low power operating range, as the signal power of the input radio frequency signal increases, as shown in FIG. 7, the current of the branch in which the first main amplifier M1 is located gradually increases, and the current of the branch in which the first auxiliary amplifier A1 is located and the current of the branch in which the second auxiliary amplifier A2 is located remain 0; as shown in FIG. 8, the voltage of the branch in which the first main amplifier M1 is located, the voltage of the branch in which the first auxiliary amplifier A1 is located, and the voltage of the branch in which the second auxiliary amplifier A2 is located all gradually increase; and as shown in FIG. 9, the impedance of the branch in which the first main amplifier M1 is located remains constant, and the impedance of the branch in which the first auxiliary amplifier A1 is located and the impedance of the branch in which the second auxiliary amplifier A2 is located remain infinite. In this case, a radio frequency signal output by the first main power amplifier M1 is used as the second radio frequency signal. As shown in FIG. 10, at a saturation power point -11 dB in the low power operating range, the first power amplification system 20A can maintain high back-off conversion efficiency.

When the signal power of the input radio frequency signal ranges from -11 dB to -5 dB, the first power amplification system 20A shown in (a) in FIG. 6 is in the medium power operating range. In this case, the first main amplifier M1 and the first auxiliary amplifier A1 operate, and the second auxiliary amplifier A2 does not operate. As shown in FIG. 7, the current of the branch in which the first main amplifier M1 is located gradually increases until a largest current, the current of the branch in which the first auxiliary amplifier A1 is located gradually increases, and the current of the branch in which the second auxiliary amplifier A2 is located remains 0. As shown in FIG. 8, the voltage of the branch in which the first main amplifier M1 is located remains a largest voltage value, the voltage of the first auxiliary amplifier A1 gradually increases to the largest voltage value, and the voltage of the second auxiliary amplifier A2 gradually increases. After the first auxiliary amplifier A1 is enabled to operate, as the signal power of the input radio frequency signal increases, impedance inversion may be implemented based on the first wavelength line L1, to ensure that signal power of the radio frequency signal output by the first main amplifier M1 can still increase in the medium power operating range. In this case, as shown in FIG. 9, the load impedance of the branch in which the second auxiliary amplifier A2 is located remains infinite, and the load impedance of the branch in which the first auxiliary amplifier A1 is located gradually decreases. The impedance inversion based on the first wavelength line L1 reduces the load impedance of the branch in which the first main amplifier M1 is located. In this case, as shown in FIG. 7 and FIG. 8, although the voltage of the branch in which the first main amplifier M1 is located remains unchanged, the load impedance of the branch in which the first main amplifier M1 is located decreases, and therefore the current of the branch in which the first main amplifier M1 gradually increases, so that the signal power of the radio frequency signal output by the first main amplifier M1 can still increase with the signal power of the input radio frequency signal. Under the action of load pull between the first main amplifier M1 and the first auxiliary amplifier A1, the second radio frequency signal may be obtained by performing power combination on radio frequency signals output by the first main amplifier M1 and the first auxiliary amplifier A1. The second wavelength line L2 and the seventh wavelength line L7 may be used to perform output impedance matching when the second radio frequency signal is input. As shown in FIG. 10, at a saturation power point -5 dB in the medium power operating range, the first power amplification system 20A can maintain high back-off conversion efficiency.

When the signal power of the input radio frequency signal of the first power amplification system 20A shown in (a) in FIG. 6 ranges from -5 dB to 0 dB, the first power amplification system 20A is in the high power operating range. In this case, the first main amplifier M1, the first auxiliary amplifier A1, and the second auxiliary amplifier A2 all operate. As shown in FIG. 7, the current of the branch in which the first main amplifier M1 is located remains unchanged, the current of the branch in which the first auxiliary amplifier A1 is located and the current of the branch the second auxiliary amplifier A2 is located gradually increase to a largest value. As shown in FIG. 8, the voltage of the branch in which the first main amplifier M1 is located remains unchanged, the voltage of the branch in which the first auxiliary amplifier A1 is located gradually increases to a largest value, and the voltage of the branch in which the second auxiliary amplifier A2 is located also gradually increases. In this case, load impedance conversion of the three branches is shown in FIG. 9. Impedance inversion is separately implemented via the first wavelength line L1 and the second wavelength line L2, and output impedance matching is performed with reference to the seventh wavelength line L7. Under the action of load pull, the second radio frequency signal may be obtained by performing power combination on radio frequency signals output by the first main amplifier M1, the first auxiliary amplifier A1, and the second auxiliary amplifier A2. As shown in FIG. 10, at a saturation power point 0 dB in the high power operating range, the first power amplification system 20A can maintain high full-load conversion efficiency.

In some examples, as shown in (b) in FIG. 6, in actual application, the multi-branch Doherty architecture based on the structure in (a) in FIG. 6 further includes a third wavelength line L3, a fourth wavelength line L4, a fifth wavelength line L5, and a sixth wavelength line L6. The output port of the first auxiliary amplifier A1 is coupled to the second port of the first wavelength line L1 via the third wavelength line L3 and the fourth wavelength line L4. The output port of the second auxiliary amplifier A2 is coupled to the second port of the second wavelength line L2 via the fifth wavelength line L5 and the sixth wavelength line L6. The second radio frequency signal is obtained by performing power combination on a plurality of radio frequency signals based on the first wavelength line L1, the second wavelength line L2, the third wavelength line L3, the fourth wavelength line L4, the fifth wavelength line L5, the sixth wavelength line L6, and the seventh wavelength line L7. A diagram of a power combination effect of the structure shown in (b) in FIG. 6 is consistent with the variations recorded in FIG. 7, FIG. 8, FIG. 9, and FIG. 10. Details are not described herein again. In some examples, impedance adjustment may be performed in a post-stage component of the first amplification system 20A, to omit the seventh wavelength line L7. In the embodiment shown in (b) in FIG. 6 of this application, the first power amplification system 20A needs at least six wavelength lines as impedance conversion lines for power combination, to obtain the second radio frequency signal. In this case, compared with the embodiment shown in (b) in FIG. 5, in the embodiment shown in (b) in FIG. 6, as a quantity of branches increases, a quantity of impedance conversion lines also greatly increases. As a result, area overheads of the first power amplification system 20A sharply increase.

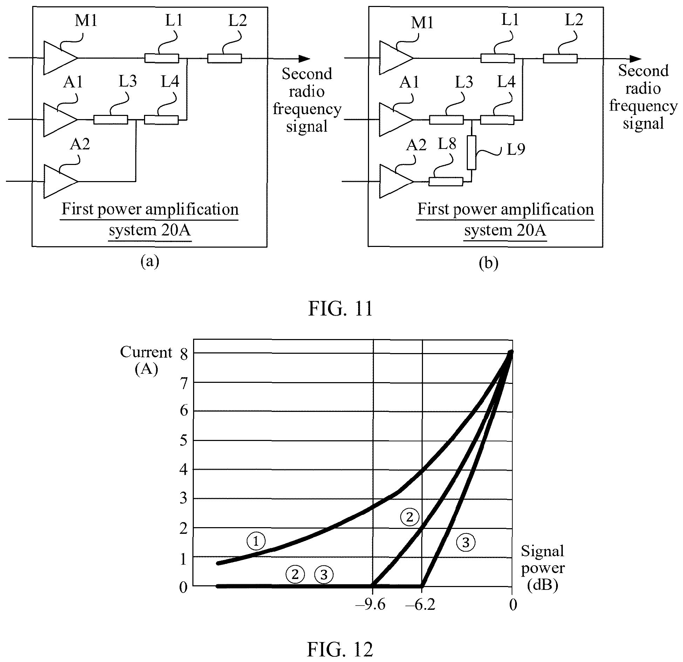

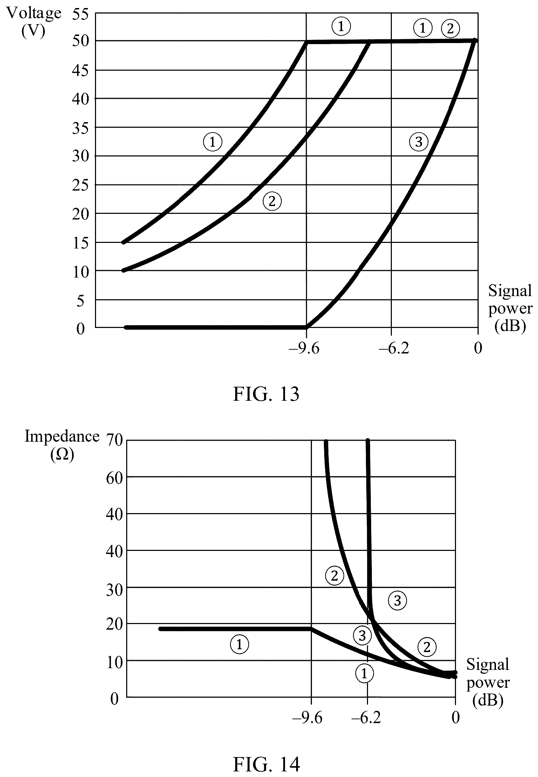

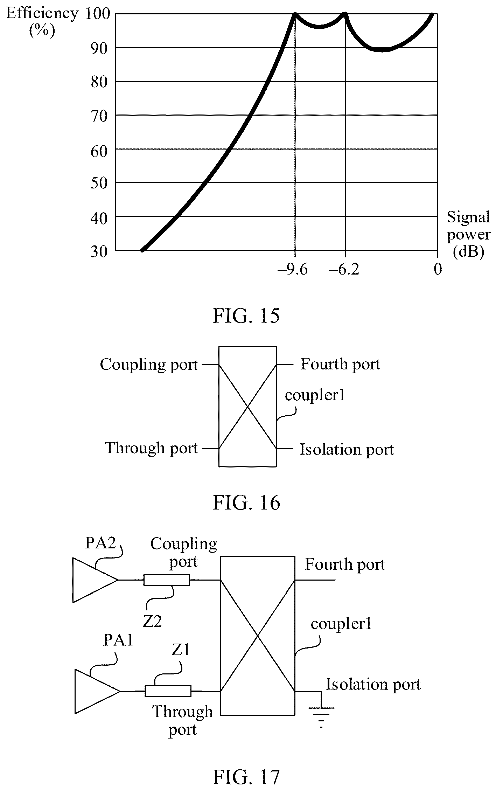

For example, when the first power amplification system 20A is based on a Doherty architecture including three branches, as shown in (a) in FIG. 11, the first power amplification system 20A includes a first main amplifier M1, a first auxiliary amplifier A1, a second auxiliary amplifier A2, a first wavelength line L1, a second wavelength line L2, a third wavelength line L3, and a fourth wavelength line L4. An output port of the first main amplifier M1 is coupled to a first port of the first wavelength line L1. A second port of the first wavelength line L1 is coupled to a first port of the second wavelength line L2. A second port of the second wavelength line L2 is configured to output a second radio frequency signal. An output port of the first auxiliary amplifier A1 is coupled to a first port of the third wavelength line L3. A second port of the third wavelength line L3 is coupled to a first port of the fourth wavelength line L4. A second port of the fourth wavelength line L4 is coupled to the second port of the first wavelength line L1. FIG. 12, FIG. 13, FIG. 14, and FIG. 15 each are a diagram of a change curve of a circuit parameter and a power of an input radio frequency signal of the first power amplification system 20A shown in (a) in FIG. 11. FIG. 12 is a diagram of a change curve of a current of each branch and a power of an input radio frequency signal. FIG. 13 is a diagram of a change curve of a voltage of each branch and a power of an input radio frequency signal. FIG. 14 is a diagram of a change curve of a load impedance of each branch and a power of an input radio frequency signal. FIG. 15 is a diagram of a change curve of conversion efficiency and a power of an input radio frequency signal of the first power amplification system 20A. In the figures, a line ① represents a branch in which the first main amplifier M1 is located, a line ② represents a branch in which the first auxiliary amplifier A1 is located, and a line ③ represents a branch in which the second auxiliary amplifier A2 is located. For example, 0 dB is a maximum operating power point of the first power amplification system 20A.

When the signal power of the input radio frequency signal of the first power amplification system 20A shown in (a) in FIG. 11 is below -9.6 dB, the first power amplification system 20A is in the low power operating range. In this case, the first main amplifier M1 operates, and the first auxiliary amplifier A1 and the second auxiliary amplifier A2 do not operate. In the low power operating range, as the signal power of the input radio frequency signal increases, as shown in FIG. 12, the current of the branch in which the first main amplifier M1 is located gradually increases, and the current of the branch in which the first auxiliary amplifier A1 is located and the current of the branch in which the second auxiliary amplifier A2 is located remain 0; as shown in FIG. 13, the voltage of the branch in which the first main amplifier M1 is located and the voltage of the branch in which the first auxiliary amplifier A1 is located gradually increase, and the voltage of the branch in which the second auxiliary amplifier A2 is located is 0; and as shown in FIG. 14, the impedance of the branch in which the first main amplifier M1 is located remains constant, and the impedance of the branch in which the first auxiliary amplifier A1 is located and the impedance of the branch in which the second auxiliary amplifier A2 is located remain infinite. In this case, a radio frequency signal output by the first main power amplifier M1 is used as the second radio frequency signal. As shown in FIG. 15, at a saturation power point - 9.6 dB in the low power operating range, the first power amplification system 20A can maintain high back-off conversion efficiency.

When the signal power of the input radio frequency signal ranges from -9.6 dB to -6.2 dB, the first power amplification system 20A shown in (a) in FIG. 11 is in the medium power operating range. In this case, the first main amplifier M1 and the first auxiliary amplifier A1 operate, and the second auxiliary amplifier A2 does not operate. As shown in FIG. 12, the current of the branch in which the first main amplifier M1 is located and the current of the branch in which the first auxiliary amplifier A1 is located gradually increase, and the current of the branch in which the second auxiliary amplifier A2 is located remains 0. As shown in FIG. 13, the voltage of the branch in which the first main amplifier M1 is located remains a largest voltage value, the voltage of the first auxiliary amplifier A1 gradually increases to the largest voltage value, and the voltage of the second auxiliary amplifier A2 gradually increases. As shown in FIG. 12 and FIG. 13, in the medium power operating range in which the first auxiliary amplifier A1 is enabled to operate, the voltage of the branch in which the first main amplifier M1 is located remains unchanged. However, as shown in FIG. 14, impedance inversion may be implemented based on the first wavelength line L1. To be specific, as shown in FIG. 14, after the first auxiliary amplifier A1 is enabled to operate, as the signal power of the input radio frequency signal increases, the first wavelength line L1 reduces the load impedance of the branch in which the first main amplifier M1 is located, and therefore the current of the branch in which the first main amplifier M1 is located increases, so that signal power of the radio frequency signal output by the first main amplifier M1 can still increase in the medium power operating range. In this case, the load impedance of the branch in which the second auxiliary amplifier A2 is located still remains infinite, and the load impedance of the branch in which the first auxiliary amplifier A1 is located gradually decreases. Under the action of load pull between the first main amplifier M1 and the first auxiliary amplifier A1, the second radio frequency signal may be obtained by performing power combination on radio frequency signals output by the first main amplifier M1 and the first auxiliary amplifier A1. The second wavelength line L2, the third wavelength line L3, and the fourth wavelength line L4 may be used to perform output impedance matching when the second radio frequency signal is input. As shown in FIG. 15, at a saturation power point -6.2 dB in the medium power operating range, the first power amplification system 20A can maintain high back-off conversion efficiency.

When the signal power of the input radio frequency signal of the first power amplification system 20A shown in (a) in FIG. 11 ranges from -6.2 dB to 0 dB, the first power amplification system 20A is in the high power operating range. In this case, the first main amplifier M1, the first auxiliary amplifier A1, and the second auxiliary amplifier A2 all operate. As shown in FIG. 12, the current of the branch in which the first main amplifier M1 is located, the current of the branch in which the first auxiliary amplifier A1 is located, and the current of the branch the second auxiliary amplifier A2 is located gradually increase to a largest value of a saturation power point. As shown in FIG. 13, the voltage of the branch in which the first main amplifier M1 is located and the voltage of the branch in which the first auxiliary amplifier A1 is located remain a largest value, and the voltage of the branch in which the second auxiliary amplifier A2 is located also gradually increases to the largest value. In this case, load impedance conversion of the three branches is shown in FIG. 14. Impedance inversion is separately implemented via the first wavelength line L1 and the third wavelength line L3, and output impedance matching is performed with reference to the second wavelength line L2 and the fourth wavelength line L4. Under the action of load pull, the second radio frequency signal may be obtained by performing power combination on radio frequency signals output by the first main amplifier M1, the first auxiliary amplifier A1, and the second auxiliary amplifier A2. As shown in FIG. 15, at a saturation power point 0 dB in the high power operating range, the first power amplification system 20A can maintain high full-load conversion efficiency.

In some examples, the Doherty architectures shown in FIG. 5, FIG. 6, and FIG. 11 may be further transformed to obtain an inverse Doherty architecture, an asymmetric Doherty architecture, or the like.

In the first power amplification system 20A that includes the structures shown in FIG. 5, FIG. 6, and FIG. 11 or the Doherty architecture obtained by transforming the structures, as a quantity of branches in the Doherty architecture increases, a larger back-off amount may be obtained, and requirements for increasing conversion efficiency and reducing quiescent power consumption in a larger bandwidth are met. However, in these Doherty architectures, wavelength lines used as impedance conversion lines are needed for power combination on radio frequency signals output by a plurality of branches. However, the wavelength lines cause large area overheads, and as the quantity of branches increases, the area overheads of the wavelength lines also sharply increase, limiting development of the Doherty architecture.

To reduce the area overheads caused by the wavelength lines, in some possible implementations, the power amplification system 20 shown in FIG. 4 may be a second power amplification system that combines a Doherty architecture and a hybrid coupler. The second power amplification system includes a hybrid coupler, a first impedance conversion line, a second impedance conversion line, and at least two power amplifiers. The at least two power amplifiers include a first amplifier and a second amplifier. An output port of the first amplifier is coupled to the hybrid coupler via the first impedance conversion line. An output port of the second amplifier is coupled to the hybrid coupler via the second impedance conversion line. The first amplifier and the second amplifier each are configured to output one radio frequency signal. The hybrid coupler is configured to: perform impedance conversion with the first impedance conversion line and/or the second impedance conversion line; and output a combined radio frequency signal from a fourth port of the hybrid coupler. The combined radio frequency signal is obtained by combining a first radio frequency signal and a second radio frequency signal. In embodiments of this application, in the second power amplification system, the hybrid coupler may be equivalent to a wavelength line, and performs impedance conversion with the first impedance conversion line and/or the second impedance conversion line, to implement load pull between a plurality of branches. Based on the hybrid coupler, power combination for the plurality of branches can be implemented while reducing a quantity of wavelength lines, so that area overheads of the power amplification system 20 can be reduced while achieving high back-off conversion efficiency, high full-load conversion efficiency, low quiescent power consumption, and the like.

In some possible implementations, as shown in FIG. 16, a hybrid coupler coupler1 includes four ports. When a fourth port of the hybrid coupler coupler1 is used as a reference, a coupling port, a through port, and an isolation port of the hybrid coupler are distributed as shown in FIG. 16. The fourth port is an output port of the hybrid coupler. When the hybrid coupler coupler1 is equivalent to a wavelength line, an equivalent effect that can be achieved varies with a status of connection of the coupling port, the through port, and the isolation port of the hybrid coupler. For example, in some examples, one of the coupling port, the through port, and the isolation port may be grounded. In some examples, one of the coupling port, the through port, and the isolation port may not be used. In some examples, two of the coupling port, the through port, and the isolation port may be grounded, or two of the coupling port, the through port, and the isolation port may not be used. In some examples, the coupling port, the through port, and the isolation port each may be coupled to one branch.

In some possible implementations, a third port of the hybrid coupler coupler1 may be grounded:

In some examples, when the third port of the hybrid coupler coupler1 is grounded, the second power amplification system is a Doherty architecture including two branches. As shown in FIG. 17, a second power amplification system 20B includes a first amplifier PA1, a second amplifier PA2, a first impedance conversion line Z1, and a second impedance conversion line Z2. An output port of the first amplifier PA1 is coupled to a first port of the hybrid coupler coupler1 via the first impedance conversion line Z1. An output port of the second amplifier PA2 is coupled to a second port of the hybrid coupler coupler1 via the second impedance conversion line Z2. A minimum operating power of the first amplifier PA1 is less than a minimum operating power of the second amplifier PA2. In FIG. 17, power combination is performed on radio frequency signals output by the first amplifier PA1 and the second amplifier PA2 through the hybrid coupler coupler1, to obtain a combined radio frequency signal. The combined radio frequency signal may be used as a second radio frequency signal output by the second power amplification system 20B. In the embodiment shown in FIG. 17, the third port of the hybrid coupler coupler1 is an isolation port relative to the fourth port of the hybrid coupler coupler1, the first port of the hybrid coupler coupler1 is a through port relative to the fourth port of the hybrid coupler coupler1, and the second port of the hybrid coupler coupler1 is a coupling port relative to the fourth port of the hybrid coupler coupler1. Although not shown, in some other examples, the third port of the hybrid coupler coupler1 may be a through port relative to the fourth port of the hybrid coupler coupler1, the first port of the hybrid coupler coupler1 may be an isolation port relative to the fourth port of the hybrid coupler coupler1, and the second port of the hybrid coupler coupler1 may be a coupling port relative to the fourth port of the hybrid coupler coupler1. In embodiments of this application, characteristics of impedance conversion and load pull in the architecture of the second power amplification system 20B shown in FIG. 17 are consistent with characteristics of impedance conversion and load pull in the embodiment shown in FIG. 5. Area overheads of the hybrid coupler coupler1 are less than area overheads of wavelength lines used as impedance conversion lines. Compared with the implementation in (b) in FIG. 5, in the embodiment shown in FIG. 17, reduction of two wavelength lines is implemented based on one hybrid coupler coupler1, greatly reducing area overheads while achieving back-off conversion efficiency, full-load conversion efficiency, and quiescent power consumption in the embodiment in (b) in FIG. 5.

In some examples, when the structure including two branches recorded in FIG. 17 and the related embodiment of FIG. 17 is used in the structure including three branches, the second power amplification system 20B further includes a third amplifier.

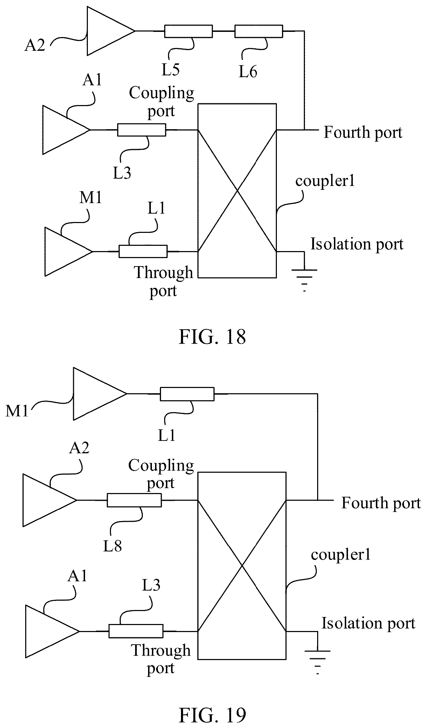

In some examples, when the two-branch Doherty architecture shown in FIG. 17 is used in a three-branch Doherty architecture, the power amplification system further includes a third amplifier. The output port of the first amplifier PA1 is coupled to the first port of the hybrid coupler via the first impedance conversion line. The output port of the second amplifier PA2 is coupled to the second port of the hybrid coupler via the second impedance conversion line. An output port of the third amplifier is coupled to the fourth port of the hybrid coupler. The minimum operating power of the second amplifier PA2 is less than a minimum operating power of the third amplifier. The minimum operating power of the first amplifier PA1 is less than the minimum operating power of the second amplifier PA2. For example, as shown in FIG. 18, the second power amplification system 20B includes a first main amplifier M1, a first auxiliary amplifier A1, a second auxiliary amplifier A2, a first wavelength line L1, and a third wavelength line L3. An output port of the first main amplifier M1 is coupled to the first port of the hybrid coupler coupler1 via the first wavelength line L1. An output port of the first auxiliary amplifier A1 is coupled to the second port of the hybrid coupler coupler1 via the third wavelength line L3. An output port of the second auxiliary amplifier A2 is coupled to the fourth port of the hybrid coupler coupler1. In this case, the first wavelength line L1 in FIG. 18 may correspond to the first impedance conversion line Z1 in FIG. 17, the third wavelength line L3 in FIG. 18 may correspond to the second impedance conversion line Z2, the first main amplifier M1 in FIG. 18 may correspond to the first amplifier PA1 in FIG. 17, and the first auxiliary amplifier A1 in FIG. 18 may correspond to the second amplifier PA2 in FIG. 17. The second auxiliary amplifier A2 in FIG. 18 is the third amplifier. In this case, the minimum operating power of the first amplifier PA1 is less than the minimum operating power of the second amplifier PA2, and the minimum operating power of the second amplifier PA2 is less than the minimum operating power of the third amplifier. For example, as shown in FIG. 18, the second power amplification system 20B may further include a fifth wavelength line L5 and a sixth wavelength line L6. The output port of the second auxiliary amplifier A2 (namely, the third amplifier) is coupled to the fourth port of the hybrid coupler coupler1 via the fifth wavelength line L5 and the sixth wavelength line L6 that are connected in series. In this case, after the hybrid coupler coupler1 combines radio frequency signals output by the first auxiliary amplifier A1 and the first main amplifier M1 to obtain a combined radio frequency signal, the combined radio frequency signal output from the fourth port of the hybrid coupler coupler1 is further combined with a radio frequency signal output by the second auxiliary amplifier A2 to obtain a second radio frequency signal. In the embodiment shown in FIG. 18, the third port of the hybrid coupler coupler1 is an isolation port relative to the fourth port of the hybrid coupler coupler1, the first port of the hybrid coupler coupler1 is a through port relative to the fourth port of the hybrid coupler coupler1, and the second port of the hybrid coupler coupler1 is a coupling port relative to the fourth port of the hybrid coupler coupler1. Although not shown, in some other examples, the third port of the hybrid coupler coupler1 may be a through port relative to the fourth port of the hybrid coupler coupler1, the first port of the hybrid coupler coupler1 may be an isolation port relative to the fourth port of the hybrid coupler coupler1, and the second port of the hybrid coupler coupler1 may be a coupling port relative to the fourth port of the hybrid coupler coupler1. In embodiments of this application, a diagram of an impedance conversion effect and a load pull effect in the embodiment shown in FIG. 18 is consistent with a diagram of an impedance conversion effect and a load pull effect in the embodiment shown in FIG. 6. In embodiments of this application, back-off conversion efficiency, full-load conversion efficiency, and quiescent power consumption that are equivalent to those in the embodiment in FIG. 6 are achieved while reducing area overheads caused by the second wavelength line L2 and the fourth wavelength line L4 in the embodiment shown in FIG. 6.

For example, when the two-branch Doherty architecture shown in FIG. 17 is used in a three-branch Doherty architecture, when the third port of the hybrid coupler coupler1 is grounded, the second power amplification system 20B further includes a third amplifier and a third impedance conversion line. The output port of the first amplifier PA1 is coupled to the first port of the hybrid coupler coupler1 via the first impedance conversion line Z1. The output port of the second amplifier PA2 is coupled to the second port of the hybrid coupler coupler1 via the second impedance conversion line Z2. An output port of the third amplifier is coupled to the fourth port of the hybrid coupler coupler1 via the third impedance conversion line. A minimum operating power of the third amplifier is less than the minimum operating power of the first amplifier PA1. The minimum operating power of the first amplifier PA1 is less than the minimum operating power of the second amplifier PA2. For example, as shown in FIG. 19, in embodiments of this application, the first amplifier PA1 may be a first auxiliary amplifier A1, the second amplifier PA2 may be a second auxiliary amplifier A2, the third amplifier may be a first main amplifier M1, the first impedance conversion line Z1 may be a third wavelength line L3, the second impedance conversion line Z2 may be an eighth wavelength line L8, and the third impedance conversion line may be a first wavelength line L1. In this case, after the hybrid coupler coupler1 combines radio frequency signals output by the first auxiliary amplifier A1 and the second auxiliary amplifier A2 to obtain a combined radio frequency signal, the combined radio frequency signal output from the fourth port of the hybrid coupler coupler1 is further combined with a radio frequency signal output by the first main amplifier M1 to obtain a second radio frequency signal. In the embodiment shown in FIG. 19, the third port of the hybrid coupler coupler1 is an isolation port relative to the fourth port of the hybrid coupler coupler1, the first port of the hybrid coupler coupler1 is a through port relative to the fourth port of the hybrid coupler coupler1, and the second port of the hybrid coupler coupler1 is a coupling port relative to the fourth port of the hybrid coupler coupler1. Although not shown, in some other examples, the third port of the hybrid coupler coupler1 may be a through port relative to the fourth port of the hybrid coupler coupler1, the first port of the hybrid coupler coupler1 may be an isolation port relative to the fourth port of the hybrid coupler coupler1, and the second port of the hybrid coupler coupler1 may be a coupling port relative to the fourth port of the hybrid coupler coupler1. In this application, a diagram of an impedance conversion effect and a load pull effect in the embodiment shown in FIG. 19 is consistent with a diagram of an impedance conversion effect and a load pull effect in the embodiment shown in FIG. 11. In embodiments of this application, back-off conversion efficiency, full-load conversion efficiency, and quiescent power consumption that are equivalent to those in the embodiment in FIG. 11 are achieved while reducing area overheads caused by the fourth wavelength line L4 and a ninth wavelength line L9 in the embodiment shown in FIG. 11.

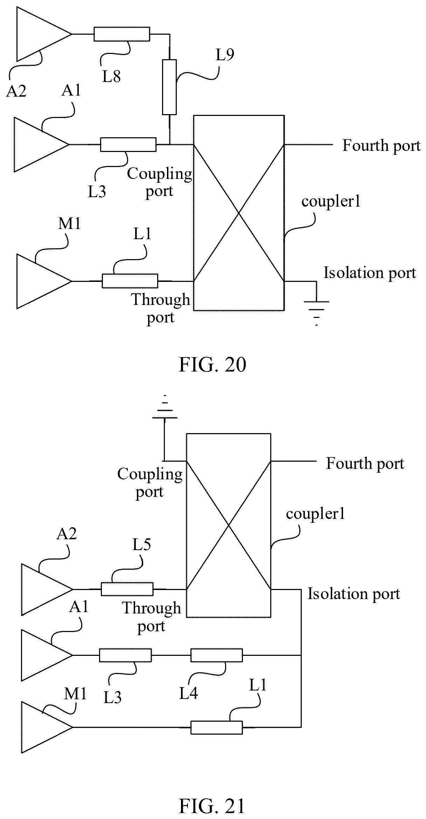

In some examples, when the two-branch Doherty architecture shown in FIG. 17 is used in a three-branch Doherty architecture, when the third port of the hybrid coupler coupler1 is grounded, the second power amplification system 20B further includes a third amplifier, a third impedance conversion line, and a fourth impedance conversion line. The output port of the first amplifier PA1 is coupled to the first port of the hybrid coupler coupler1 via the first impedance conversion line Z1. The output port of the second amplifier PA2 is coupled to the first port of the hybrid coupler coupler1 via the second impedance conversion line Z2 and the fourth impedance conversion line that are connected in series. An output port of the third amplifier is coupled to the second port of the hybrid coupler coupler1 via the third impedance conversion line. A minimum operating power of the third amplifier is less than the minimum operating power of the first amplifier PA1. The minimum operating power of the first amplifier PA1 is less than the minimum operating power of the second amplifier PA2. For example, as shown in FIG. 20, in embodiments of this application, the first amplifier PA1 may be a first auxiliary amplifier A1, the second amplifier PA2 may be a second auxiliary amplifier A2, the third amplifier may be a first main amplifier M1, the first impedance conversion line Z1 may be a third wavelength line L3, the second impedance conversion line Z2 may be an eighth wavelength line L8, the third impedance conversion line may be a first wavelength line L1, and the fourth impedance conversion line may be a ninth wavelength line L9. In this case, radio frequency signals output by the second auxiliary amplifier A2 and the first auxiliary amplifier A1 are combined and then output to the coupling port of the hybrid coupler coupler1, a radio frequency signal output by the first main amplifier M1 is transmitted to the through port of the hybrid coupler coupler1, and a combined radio frequency signal is output from the fourth port of the hybrid coupler coupler1. The combined radio frequency signal may be used as a second radio frequency signal output by the second power amplification system 20B. In the embodiment shown in FIG. 20, the third port of the hybrid coupler coupler1 is an isolation port relative to the fourth port of the hybrid coupler coupler1, the first port of the hybrid coupler coupler1 is a through port relative to the fourth port of the hybrid coupler coupler1, and the second port of the hybrid coupler coupler1 is a coupling port relative to the fourth port of the hybrid coupler coupler1. Although not shown, in some other examples, the third port of the hybrid coupler coupler1 may be a through port relative to the fourth port of the hybrid coupler coupler1, the first port of the hybrid coupler coupler1 may be an isolation port relative to the fourth port of the hybrid coupler coupler1, and the second port of the hybrid coupler coupler1 may be a coupling port relative to the fourth port of the hybrid coupler coupler1. In this application, a diagram of an impedance conversion effect and a load pull effect in the embodiment shown in FIG. 20 is consistent with a diagram of an impedance conversion effect and a load pull effect in the embodiment shown in FIG. 11. In embodiments of this application, back-off conversion efficiency, full-load conversion efficiency, and quiescent power consumption that are equivalent to those in the embodiment in FIG. 11 are achieved while reducing area overheads caused by the second wavelength line L2 and the fourth wavelength line L4 in the embodiment shown in FIG. 11.

In some possible implementations, when the third port of the hybrid coupler coupler1 is grounded, the second power amplification system 20B may include three branches. In this case, the second power amplification system 20B further includes a third amplifier. The output port of the first amplifier PA2 is coupled to the first port of the hybrid coupler via the first impedance conversion line. An output port of the third amplifier is coupled to the first port of the hybrid coupler. The output port of the second amplifier PA2 is coupled to the second port of the hybrid coupler via the second impedance conversion line. In some examples, the second power amplification system 20B further includes a third impedance conversion line and a fourth impedance conversion line. The output port of the third amplifier is coupled to the first port of the hybrid coupler via the third impedance conversion line and the fourth impedance conversion line that are connected in series. For example, as shown in FIG. 21, in embodiments of this application, the first amplifier PA1 may be a first main amplifier M1, the second amplifier PA2 may be a second auxiliary amplifier A2, the third amplifier may be a first auxiliary amplifier A1, the first impedance conversion line may be a first wavelength line L1, the second impedance conversion line may be a fifth wavelength line L5, the third impedance conversion line may be a third wavelength line L3, and the fourth impedance conversion line may be a fourth wavelength line L4. In this case, radio frequency signals output by the first main amplifier M1 and the first auxiliary amplifier A1 are combined and then transmitted to the isolation port of the hybrid coupler coupler1, and a radio frequency signal output by the second auxiliary amplifier A2 is transmitted to the through port of the hybrid coupler coupler1. Then, a combined radio frequency signal is output from the fourth port of the hybrid coupler coupler1. In the embodiment shown in FIG. 21, the third port of the hybrid coupler coupler1 is a coupling port relative to the fourth port of the hybrid coupler coupler1, the first port of the hybrid coupler coupler1 is an isolation port relative to the fourth port of the hybrid coupler coupler1, and the second port of the hybrid coupler coupler1 is a through port relative to the fourth port of the hybrid coupler coupler1. Although not shown, in some other examples, the third port of the hybrid coupler coupler1 may be a coupling port relative to the fourth port of the hybrid coupler coupler1, the first port of the hybrid coupler coupler1 may be a through port relative to the fourth port of the hybrid coupler coupler1, and the second port of the hybrid coupler coupler1 may be an isolation port relative to the fourth port of the hybrid coupler coupler1. In this application, a diagram of an impedance conversion effect and a load pull effect in the embodiment shown in FIG. 21 is consistent with a diagram of an impedance conversion effect and a load pull effect in the embodiment shown in FIG. 6. In embodiments of this application, back-off conversion efficiency, full-load conversion efficiency, and quiescent power consumption that are equivalent to those in the embodiment in FIG. 6 are achieved while reducing area overheads caused by the second wavelength line L2 and the sixth wavelength line L6 in the embodiment shown in FIG. 6.

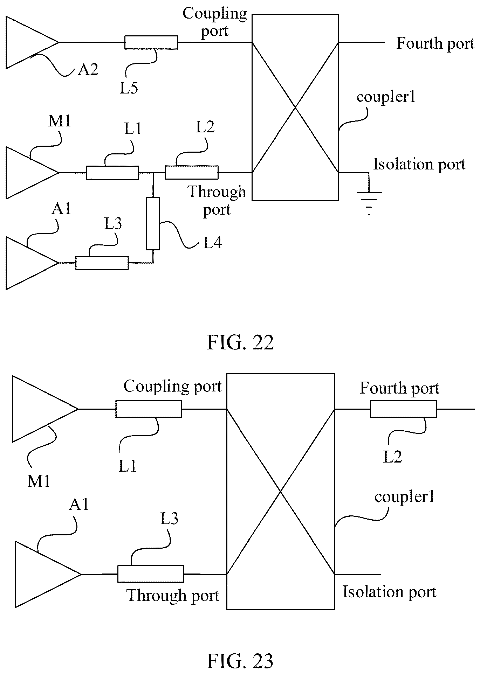

In some possible implementations, the second power amplification system 20B further includes the first amplifier, the second amplifier, a third amplifier, the first impedance conversion line, the second impedance conversion line, and a third impedance conversion line. The output port of the first amplifier is coupled to the first port of the hybrid coupler via the first impedance conversion line and the third impedance conversion line that are connected in series. An output port of the third amplifier is coupled to a first port of the third impedance conversion line, and is coupled to the first port of the hybrid coupler via a second port of the third impedance conversion line. The output port of the second amplifier is coupled to the second port of the hybrid coupler via the second impedance conversion line. A minimum operating power of the third amplifier is greater than the minimum operating power of the first amplifier and less than the minimum operating power of the second amplifier. In some examples, the second power amplification system 20 further includes a fourth impedance conversion line and a fifth impedance conversion line. The output port of the third amplifier is coupled to the first port of the third impedance conversion line via the fourth impedance conversion line and the fifth impedance conversion line that are connected in series. For example, as shown in FIG. 22, the first amplifier may be a first main amplifier M1, the second amplifier may be a second auxiliary amplifier A2, the third amplifier may be a first auxiliary amplifier A1, the first impedance conversion line may be a first wavelength line L1, the second impedance conversion line may be a fifth wavelength line L5, the third impedance conversion line may be a second wavelength line L2, the fourth impedance conversion line may be a third wavelength line L3, and the fifth impedance conversion line may be a fourth wavelength line L4. In this case, radio frequency signals output by the first main amplifier M1 and the first auxiliary amplifier A1 are combined and then transmitted to the through port of the hybrid coupler coupler1, and a radio frequency signal output by the second auxiliary amplifier A2 is transmitted to the coupling port of the hybrid coupler coupler1. Then, a combined radio frequency signal is output from the fourth port of the hybrid coupler coupler1. In the embodiment shown in FIG. 22, the third port of the hybrid coupler coupler1 is an isolation port relative to the fourth port of the hybrid coupler coupler1, the first port of the hybrid coupler coupler1 is a through port relative to the fourth port of the hybrid coupler coupler1, and the second port of the hybrid coupler coupler1 is a coupling port relative to the fourth port of the hybrid coupler coupler1. Although not shown, in some other examples, the third port of the hybrid coupler coupler1 may be a through port relative to the fourth port of the hybrid coupler coupler1, the first port of the hybrid coupler coupler1 may be an isolation port relative to the fourth port of the hybrid coupler coupler1, and the second port of the hybrid coupler coupler1 may be a coupling port relative to the fourth port of the hybrid coupler coupler1. In this application, a diagram of an impedance conversion effect and a load pull effect in the embodiment shown in FIG. 22 is consistent with a diagram of an impedance conversion effect and a load pull effect in the embodiment shown in FIG. 6. In embodiments of this application, back-off conversion efficiency, full-load conversion efficiency, and quiescent power consumption that are equivalent to those in the embodiment in FIG. 11 are achieved while reducing area overheads caused by the sixth wavelength line L6 and the seventh wavelength line L7 in the embodiment shown in FIG. 6.

In some implementations, a third port of the hybrid coupler coupler1 may not be used:

In some examples, when the third port of the hybrid coupler coupler1 is not used, the second power amplification system 20B is based on two branches. In this case, the second power amplification system 20B includes a first amplifier, a second amplifier, a first impedance conversion line, a second impedance conversion line, and a third impedance conversion line. An output port of the first amplifier is coupled to a first port of the hybrid coupler via the first impedance conversion line. An output port of the second amplifier is coupled to a second port of the hybrid coupler via the second impedance conversion line. The fourth port of the hybrid coupler is coupled to the third impedance conversion line. As shown in FIG. 23, the first amplifier may be a first main amplifier M1, the second amplifier may be a first auxiliary amplifier A1, the first impedance conversion line may be a first wavelength line L1, the second impedance conversion line may be a third wavelength line L3, and the third impedance conversion line may be a second wavelength line L2. In the embodiment shown in FIG. 23, the third port of the hybrid coupler coupler1 is an isolation port relative to the fourth port of the hybrid coupler coupler1, the first port of the hybrid coupler coupler1 is a coupling port relative to the fourth port of the hybrid coupler coupler1, and the second port of the hybrid coupler coupler1 is a through port relative to the fourth port of the hybrid coupler coupler1. Although not shown, in some other examples, the third port of the hybrid coupler coupler1 may be a through port relative to the fourth port of the hybrid coupler coupler1, the first port of the hybrid coupler coupler1 may be a coupling port relative to the fourth port of the hybrid coupler coupler1, and the second port of the hybrid coupler coupler1 may be an isolation port relative to the fourth port of the hybrid coupler coupler1. In the embodiment shown in FIG. 23 of this application, through the hybrid coupler coupler1, back-off conversion efficiency, full-load conversion efficiency, and quiescent power consumption that are equivalent to those in the embodiment in FIG. 5 are achieved while reducing area overheads caused by the fourth wavelength line L4 in the embodiment shown in FIG. 5.

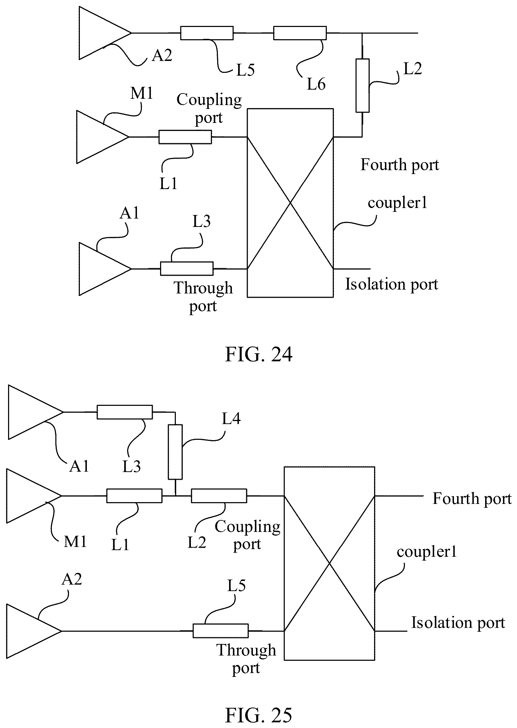

In some examples, when the third port of the hybrid coupler coupler1 is not used, based on the architecture including two branches in FIG. 23 and the related embodiment of FIG. 23, the second power amplification system 20B may be of an architecture including three branches. In this case, the second power amplification system 20B includes the first amplifier, the second amplifier, a third amplifier, the first impedance conversion line, the second impedance conversion line, and a third impedance conversion line. The output port of the first amplifier is coupled to the first port of the hybrid coupler via the first impedance conversion line. The output port of the second amplifier is coupled to the second port of the hybrid coupler via the second impedance conversion line. A first port of the third impedance conversion line is coupled to the fourth port of the hybrid coupler. An output port of the third amplifier is coupled to a second port of the third impedance conversion line. A minimum operating power of the first amplifier is less than a minimum operating power of the second amplifier. The minimum operating power of the second amplifier is less than a minimum operating power of the third amplifier. For example, the second power amplification system 20B further includes a fourth impedance conversion line and a fifth impedance conversion line. The output port of the third amplifier is coupled to the second port of the third impedance conversion line via the fourth impedance conversion line and the fifth impedance conversion line that are connected in series. As shown in FIG. 24, the first amplifier may be a first main amplifier M1, the second amplifier may be a first auxiliary amplifier A1, the third amplifier may be a second auxiliary amplifier A2, the first impedance conversion line may be a first wavelength line L1, the second impedance conversion line may be a third wavelength line L3, the third impedance conversion line may be a second wavelength line L2, the fourth impedance conversion line may be a fifth wavelength line L5, and the fifth impedance conversion line may be a sixth wavelength line L6. In the embodiment shown in FIG. 24, the third port of the hybrid coupler coupler1 is an isolation port relative to the fourth port of the hybrid coupler coupler1, the first port of the hybrid coupler coupler1 is a coupling port relative to the fourth port of the hybrid coupler coupler1, and the second port of the hybrid coupler coupler1 is a through port relative to the fourth port of the hybrid coupler coupler1. Although not shown, in some other examples, the third port of the hybrid coupler coupler1 may be a through port relative to the fourth port of the hybrid coupler coupler1, the first port of the hybrid coupler coupler1 may be a coupling port relative to the fourth port of the hybrid coupler coupler1, and the second port of the hybrid coupler coupler1 may be an isolation port relative to the fourth port of the hybrid coupler coupler1. In the embodiment shown in FIG. 24 of this application, through the hybrid coupler coupler1, an impedance conversion effect and a load pull effect are shown in FIG. 7, FIG. 8, FIG. 9, and FIG. 10. Therefore, back-off conversion efficiency, full-load conversion efficiency, and quiescent power consumption that are equivalent to those in the embodiment in (b) in FIG. 6 are achieved while reducing area overheads caused by the fourth wavelength line L4 in the embodiment shown in (b) in FIG. 6.

In some examples, when the third port of the hybrid coupler coupler1 is not used, the second power amplification system 20B may be of an architecture including three branches. In this case, the second power amplification system 20B further includes the first amplifier, the second amplifier, a third amplifier, the first impedance conversion line, the second impedance conversion line, and a third impedance conversion line. The output port of the first amplifier is coupled to the first port of the hybrid coupler via the first impedance conversion line and the third impedance conversion line that are connected in series. The output port of the second amplifier is coupled to the second port of the hybrid coupler via the second impedance conversion line. An output port of the third amplifier is coupled to a first port of the third impedance conversion line, and is coupled to the first port of the hybrid coupler via a second port of the third impedance conversion line. A minimum operating power of the third amplifier is greater than the minimum operating power of the first amplifier and less than the minimum operating power of the second amplifier. For example, the second power amplification system 20B further includes a fourth impedance conversion line and a fifth impedance conversion line. The output port of the third amplifier is coupled to the first port of the third impedance conversion line via the fourth impedance conversion line and the fifth impedance conversion line that are connected in series. For example, as shown in FIG. 25, the first amplifier may be a first main amplifier M1, the second amplifier may be a second auxiliary amplifier A2, the third amplifier may be a first auxiliary amplifier A1, the first impedance conversion line may be a first wavelength line L1, the second impedance conversion line may be a fifth wavelength line L5, the third impedance conversion line may be a second wavelength line L2, the fourth impedance conversion line may be a third wavelength line L3, and the fifth impedance conversion line may be a fourth wavelength line L4. In the embodiment shown in FIG. 25, the third port of the hybrid coupler coupler1 is an isolation port relative to the fourth port of the hybrid coupler coupler1, the first port of the hybrid coupler coupler1 is a coupling port relative to the fourth port of the hybrid coupler coupler1, and the second port of the hybrid coupler coupler1 is a through port relative to the fourth port of the hybrid coupler coupler1. Although not shown, in some other examples, the third port of the hybrid coupler coupler1 may be a through port relative to the fourth port of the hybrid coupler coupler1, the first port of the hybrid coupler coupler1 may be a coupling port relative to the fourth port of the hybrid coupler coupler1, and the second port of the hybrid coupler coupler1 may be an isolation port relative to the fourth port of the hybrid coupler coupler1. In the embodiment shown in FIG. 25 of this application, through the hybrid coupler coupler1, an impedance conversion effect and a load pull effect are shown in FIG. 7, FIG. 8, FIG. 9, and FIG. 10. Therefore, back-off conversion efficiency, full-load conversion efficiency, and quiescent power consumption that are equivalent to those in the embodiment in (b) in FIG. 6 are achieved while reducing area overheads caused by the sixth wavelength line L6 in the embodiment shown in (b) in FIG. 6.

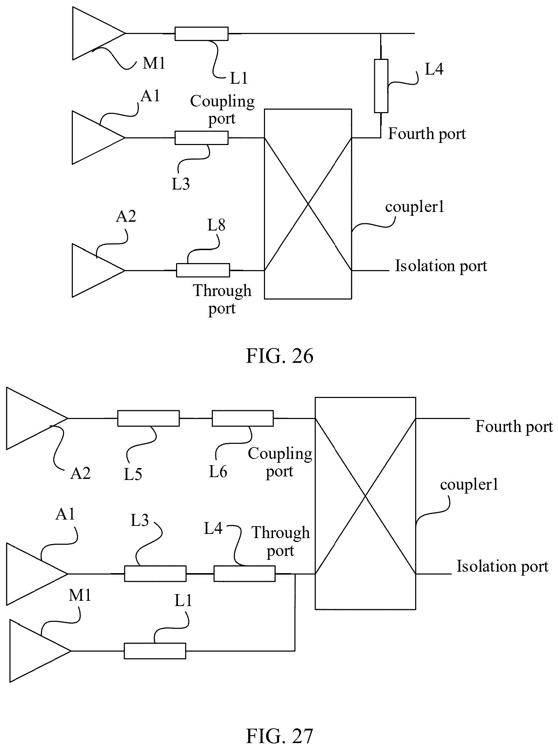

In some examples, when the third port of the hybrid coupler coupler1 is not used, the second power amplification system 20B may be of an architecture including three branches. In this case, the second power amplification system 20B further includes the first amplifier, the second amplifier, a third amplifier, the first impedance conversion line, the second impedance conversion line, a third impedance conversion line, and a fourth impedance conversion line. The output port of the first amplifier is coupled to the first port of the hybrid coupler via the first impedance conversion line. The output port of the second amplifier is coupled to the second port of the hybrid coupler via the second impedance conversion line. A first port of the fourth impedance conversion line is coupled to the fourth port of the hybrid coupler. An output port of the third amplifier is coupled to a second port of the fourth impedance conversion line via the third impedance conversion line. A minimum operating power of the third amplifier is less than the minimum operating power of the first amplifier. The minimum operating power of the first amplifier is less than the minimum operating power of the second amplifier. For example, as shown in FIG. 26, the first amplifier may be a first auxiliary amplifier A1, the second amplifier may be a second auxiliary amplifier A2, the third amplifier may be a first main amplifier M1, the first impedance conversion line may be a third wavelength line L3, the second impedance conversion line may be an eighth wavelength line L8, the third impedance conversion line may be a first wavelength line L1, and the fourth impedance conversion line may be a fourth wavelength line L4. In the embodiment shown in FIG. 26, the third port of the hybrid coupler coupler1 is an isolation port relative to the fourth port of the hybrid coupler coupler1, the first port of the hybrid coupler coupler1 is a coupling port relative to the fourth port of the hybrid coupler coupler1, and the second port of the hybrid coupler coupler1 is a through port relative to the fourth port of the hybrid coupler coupler1. Although not shown, in some other examples, the third port of the hybrid coupler coupler1 may be a through port relative to the fourth port of the hybrid coupler coupler1, the first port of the hybrid coupler coupler1 may be a coupling port relative to the fourth port of the hybrid coupler coupler1, and the second port of the hybrid coupler coupler1 may be an isolation port relative to the fourth port of the hybrid coupler coupler1. In the embodiment shown in FIG. 26 of this application, through the hybrid coupler coupler1, an impedance conversion effect and a load pull effect are shown in FIG. 12, FIG. 13, FIG. 14, and FIG. 15. Therefore, back-off conversion efficiency, full-load conversion efficiency, and quiescent power consumption that are equivalent to those in the embodiment in (b) in FIG. 11 are achieved while reducing area overheads caused by the ninth wavelength line L9 in the embodiment shown in (b) in FIG. 11.

In some examples, when the third port of the hybrid coupler coupler1 is not used, the second power amplification system 20B may be of an architecture including three branches. In this case, the second power amplification system 20B further includes the first amplifier, the second amplifier, a third amplifier, the first impedance conversion line, the second impedance conversion line, and a third impedance conversion line. The output port of the first amplifier is coupled to the first port of the hybrid coupler via the first impedance conversion line. The output port of the second amplifier is coupled to the first port of the hybrid coupler via the second impedance conversion line and the third impedance conversion line that are connected in series. An output port of the third amplifier is coupled to the second port of the hybrid coupler. The minimum operating power of the second amplifier is less than a minimum operating power of the third amplifier. For example, the second power amplification system 20B further includes a fourth impedance conversion line and a fifth impedance conversion line. The output port of the third amplifier is coupled to the second port of the hybrid coupler via the fourth impedance conversion line and the fifth impedance conversion line that are connected in series. As shown in FIG. 27, the first amplifier may be a first main amplifier M1, the second amplifier may be a first auxiliary amplifier A1, the third amplifier may be a second auxiliary amplifier A2, the first impedance conversion line may be a first wavelength line L1, the second impedance conversion line may be a third wavelength line L3, the third impedance conversion line may be a fourth wavelength line L4, the fourth impedance conversion line may be a fifth wavelength line L5, and the fifth impedance conversion line may be a sixth wavelength line L6. In the embodiment shown in FIG. 27, the third port of the hybrid coupler coupler1 is an isolation port relative to the fourth port of the hybrid coupler coupler1, the first port of the hybrid coupler coupler1 is a through port relative to the fourth port of the hybrid coupler coupler1, and the second port of the hybrid coupler coupler1 is a coupling port relative to the fourth port of the hybrid coupler coupler1. Although not shown, in some other examples, the third port of the hybrid coupler coupler1 may be a through port relative to the fourth port of the hybrid coupler coupler1, the first port of the hybrid coupler coupler1 may be an isolation port relative to the fourth port of the hybrid coupler coupler1, and the second port of the hybrid coupler coupler1 may be a coupling port relative to the fourth port of the hybrid coupler coupler1. In the embodiment shown in FIG. 27 of this application, through the hybrid coupler coupler1, an impedance conversion effect and a load pull effect are shown in FIG. 7, FIG. 8, FIG. 9, and FIG. 10. Therefore, back-off conversion efficiency, full-load conversion efficiency, and quiescent power consumption that are equivalent to those in the embodiment in (b) in FIG. 6 are achieved while reducing area overheads caused by the second wavelength line L2 in the embodiment shown in (b) in FIG. 6.

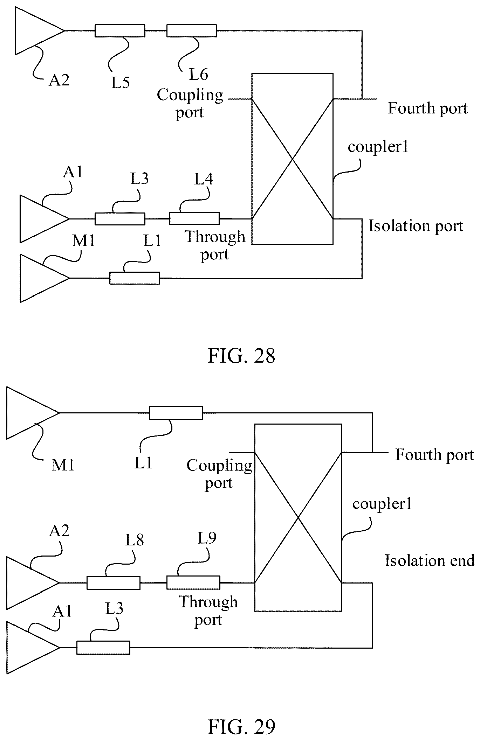

In some examples, when the third port of the hybrid coupler coupler1 is not used, the second power amplification system 20B may be of an architecture including three branches. In this case, the second power amplification system 20B further includes the first amplifier, the second amplifier, a third amplifier, the first impedance conversion line, the second impedance conversion line, and a third impedance conversion line. The output port of the first amplifier is coupled to the first port of the hybrid coupler via the first impedance conversion line. The output port of the second amplifier is coupled to the second port of the hybrid coupler via the second impedance conversion line and the third impedance conversion line that are connected in series. An output port of the third amplifier is coupled to the fourth port of the hybrid coupler. The minimum operating power of the first amplifier is less than the minimum operating power of the second amplifier. The minimum operating power of the second amplifier is less than a minimum operating power of the third amplifier. For example, the second power amplification system 20B further includes a fourth impedance conversion line and a fifth impedance conversion line. The output port of the third amplifier is coupled to the fourth port of the hybrid coupler via the fourth impedance conversion line and the fifth impedance conversion line that are connected in series. As shown in FIG. 28, the first amplifier may be a first main amplifier M1, the second amplifier may be a first auxiliary amplifier A1, the third amplifier may be a second auxiliary amplifier A2, the first impedance conversion line may be a first wavelength line L1, the second impedance conversion line may be a third wavelength line L3, the third impedance conversion line may be a fourth wavelength line L4, the fourth impedance conversion line may be a fifth wavelength line L5, and the fifth impedance conversion line may be a sixth wavelength line L6. In the embodiment shown in FIG. 28, the third port of the hybrid coupler coupler1 is a coupling port relative to the fourth port of the hybrid coupler coupler1, the first port of the hybrid coupler coupler1 is an isolation port relative to the fourth port of the hybrid coupler coupler1, and the second port of the hybrid coupler coupler1 is a through port relative to the fourth port of the hybrid coupler coupler1. Although not shown, in some other examples, the third port of the hybrid coupler coupler1 may be a coupling port relative to the fourth port of the hybrid coupler coupler1, the first port of the hybrid coupler coupler1 may be a through port relative to the fourth port of the hybrid coupler coupler1, and the second port of the hybrid coupler coupler1 may be an isolation port relative to the fourth port of the hybrid coupler coupler1. In the embodiment shown in FIG. 28 of this application, through the hybrid coupler coupler1, an impedance conversion effect and a load pull effect are shown in FIG. 7, FIG. 8, FIG. 9, and FIG. 10. Therefore, back-off conversion efficiency, full-load conversion efficiency, and quiescent power consumption that are equivalent to those in the embodiment in (b) in FIG. 6 are achieved while reducing area overheads caused by the second wavelength line L2 in the embodiment shown in (b) in FIG. 6.

In some examples, when the third port of the hybrid coupler coupler1 is not used, the second power amplification system 20B may be of an architecture including three branches. In this case, the second power amplification system 20B further includes the first amplifier, the second amplifier, a third amplifier, the first impedance conversion line, the second impedance conversion line, a third impedance conversion line, and a fourth impedance conversion line. The output port of the first amplifier is coupled to the first port of the hybrid coupler. The output port of the second amplifier is coupled to the second port of the hybrid coupler via the second impedance conversion line and the third impedance conversion line that are connected in series. An output port of the third amplifier is coupled to the fourth port of the hybrid coupler via the fourth impedance conversion line. A minimum operating power of the third amplifier is less than the minimum operating power of the first amplifier. The minimum operating power of the first amplifier is less than the minimum operating power of the second amplifier. For example, as shown in FIG. 29, the first amplifier may be a first auxiliary amplifier A1, the second amplifier may be a second auxiliary amplifier A2, the third amplifier may be a first main amplifier M1, the first impedance conversion line may be a third wavelength line L3, the second impedance conversion line may be an eighth wavelength line L8, the third impedance conversion line may be a ninth wavelength line L9, and the fourth impedance conversion line may be a first wavelength line L1. In the embodiment shown in FIG. 29, the third port of the hybrid coupler coupler1 is a coupling port relative to the fourth port of the hybrid coupler coupler1, the first port of the hybrid coupler coupler1 is an isolation port relative to the fourth port of the hybrid coupler coupler1, and the second port of the hybrid coupler coupler1 is a through port relative to the fourth port of the hybrid coupler coupler1. Although not shown, in some other examples, the third port of the hybrid coupler coupler1 may be a coupling port relative to the fourth port of the hybrid coupler coupler1, the first port of the hybrid coupler coupler1 may be a through port relative to the fourth port of the hybrid coupler coupler1, and the second port of the hybrid coupler coupler1 may be an isolation port relative to the fourth port of the hybrid coupler coupler1. In the embodiment shown in FIG. 29 of this application, through the hybrid coupler coupler1, an impedance conversion effect and a load pull effect are shown in FIG. 12, FIG. 13, FIG. 14, and FIG. 15. Therefore, back-off conversion efficiency, full-load conversion efficiency, and quiescent power consumption that are equivalent to those in the embodiment in (b) in FIG. 11 are achieved while reducing area overheads caused by the fourth wavelength line L4 in the embodiment shown in (b) in FIG. 11.

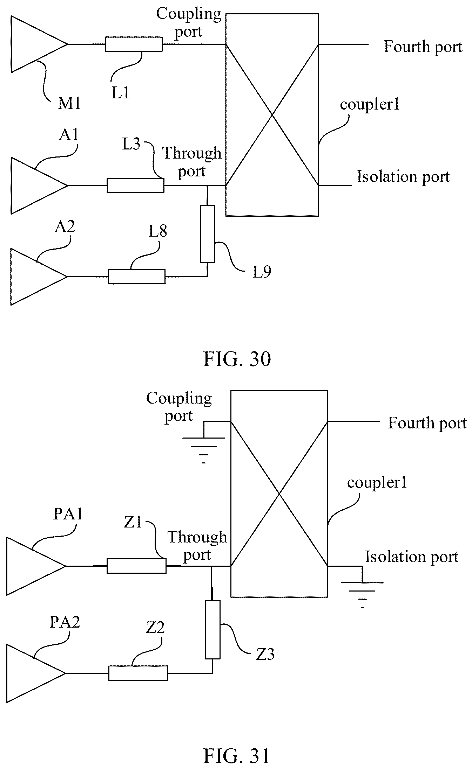

In some examples, when the third port of the hybrid coupler coupler1 is not used, the second power amplification system 20B may be of an architecture including three branches. In this case, the second power amplification system 20B further includes the first amplifier, the second amplifier, a third amplifier, the first impedance conversion line, the second impedance conversion line, a third impedance conversion line, and a fourth impedance conversion line. The output port of the first amplifier is coupled to the first port of the hybrid coupler via the first impedance conversion line. The output port of the second amplifier is coupled to the first port of the hybrid coupler via the second impedance conversion line and the third impedance conversion line that are connected in series. An output port of the third amplifier is coupled to the second port of the hybrid coupler via the fourth impedance conversion line. A minimum operating power of the third amplifier is less than the minimum operating power of the first amplifier. The minimum operating power of the first amplifier is less than the minimum operating power of the second amplifier. For example, as shown in FIG. 30, the first amplifier may be a first auxiliary amplifier A1, the second amplifier may be a second auxiliary amplifier A2, the third amplifier may be a first main amplifier M1, the first impedance conversion line may be a third wavelength line L3, the second impedance conversion line may be an eighth wavelength line L8, the third impedance conversion line may be a ninth wavelength line L9, and the fourth impedance conversion line may be a first wavelength line L1. In the embodiment shown in FIG. 30, the third port of the hybrid coupler coupler1 is an isolation port relative to the fourth port of the hybrid coupler coupler1, the first port of the hybrid coupler coupler1 is a through port relative to the fourth port of the hybrid coupler coupler1, and the second port of the hybrid coupler coupler1 is a coupling port relative to the fourth port of the hybrid coupler coupler1. Although not shown, in some other examples, the third port of the hybrid coupler coupler1 may be a through port relative to the fourth port of the hybrid coupler coupler1, the first port of the hybrid coupler coupler1 may be an isolation port relative to the fourth port of the hybrid coupler coupler1, and the second port of the hybrid coupler coupler1 may be a coupling port relative to the fourth port of the hybrid coupler coupler1. In the embodiment shown in FIG. 30 of this application, through the hybrid coupler coupler1, an impedance conversion effect and a load pull effect are shown in FIG. 12, FIG. 13, FIG. 14, and FIG. 15. Therefore, back-off conversion efficiency, full-load conversion efficiency, and quiescent power consumption that are equivalent to those in the embodiment in (b) in FIG. 11 are achieved while reducing area overheads caused by the fourth wavelength line L4 in the embodiment shown in (b) in FIG. 11.

In some possible implementations, a second port and a third port of the hybrid coupler coupler1 are grounded, or a second port and a third port of the hybrid coupler coupler1 are not used.

In some examples, when the second port and the third port of the hybrid coupler coupler1 are grounded, or the second port and the third port of the hybrid coupler coupler1 are not used, and the second power amplification system 20B includes two branches, as shown in FIG. 31, the second power amplification system 20B includes a first amplifier PA1, a second amplifier PA2, a first impedance conversion line Z1, a second impedance conversion line Z2, and a third impedance conversion line Z3. A minimum operating power of the first amplifier PA1 is less than a minimum operating power of the second amplifier PA2. An output port of the first amplifier PA1 is coupled to a first port of the hybrid coupler coupler1 via the first impedance conversion line Z1. An output port of the second amplifier PA2 is coupled to the first port of the hybrid coupler coupler1 via the second impedance conversion line Z2 and the third impedance conversion line Z3 that are connected in series. In the embodiment shown in FIG. 31, the second port and the third port of the hybrid coupler coupler1 may be respectively an isolation port and a coupling port that are relative to the fourth port of the hybrid coupler coupler1, and the first port of the hybrid coupler coupler1 is a through port relative to the hybrid coupler coupler1. Although not shown, in some other examples, the second port and the third port of the hybrid coupler coupler1 may be respectively a coupling port and a through port that are relative to the fourth port of the hybrid coupler coupler1, and the first port of the hybrid coupler coupler1 may be an isolation port relative to the fourth port of the hybrid coupler coupler1. In the embodiment shown in FIG. 31 of this application, through the hybrid coupler coupler1, an impedance conversion effect and a load pull effect are consistent with those in the embodiment shown in FIG. 5. Therefore, back-off conversion efficiency, full-load conversion efficiency, and quiescent power consumption that are equivalent to those in the embodiment in (b) in FIG. 5 are achieved while reducing area overheads caused by the fourth wavelength line L4 in the embodiment shown in (b) in FIG. 5.

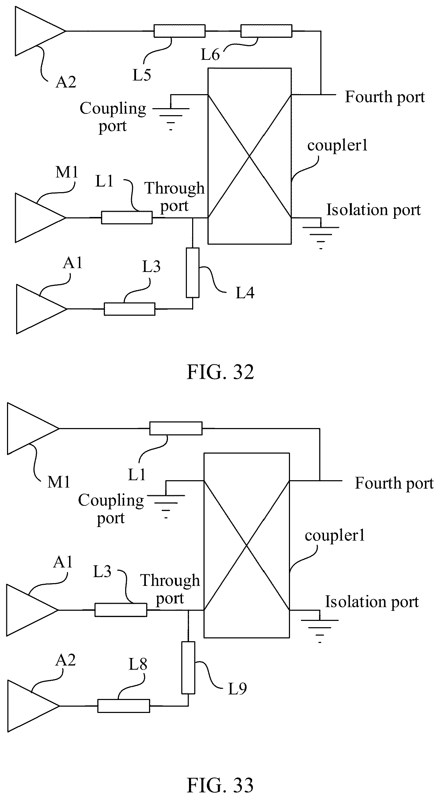

In some examples, when the second port and the third port of the hybrid coupler coupler1 are grounded, or the second port and the third port of the hybrid coupler coupler1 are not used, and the second power amplification system 20B includes three branches, based on the architecture including two branches shown in FIG. 31, the second power amplification system 20B includes the first amplifier PA1, the second amplifier PA2, a third amplifier, the first impedance conversion line Z1, the second impedance conversion line Z2, and the third impedance conversion line Z3. The minimum operating power of the first amplifier PA1 is less than the minimum operating power of the second amplifier PA2. The output port of the first amplifier PA1 is coupled to the first port of the hybrid coupler coupler1 via the first impedance conversion line Z1. The output port of the second amplifier PA2 is coupled to the first port of the hybrid coupler coupler1 via the second impedance conversion line Z2 and the third impedance conversion line Z3 that are connected in series. The fourth port of the hybrid coupler is coupled to an output port of the third amplifier. The minimum operating power of the second amplifier is less than a minimum operating power of the third amplifier. For example, the second power amplification system 20B further includes a fourth impedance conversion line and a fifth impedance conversion line. The output port of the third amplifier is coupled to the fourth port of the hybrid coupler via the fourth impedance conversion line and the fifth impedance conversion line that are connected in series. For example, as shown in FIG. 32, the first amplifier PA1 may be a first main amplifier M1, the second amplifier PA2 may be a first auxiliary amplifier A1, the third amplifier may be a second auxiliary amplifier A2, the first impedance conversion line may be a first wavelength line L1, the second impedance conversion line may be a third wavelength line L3, the third impedance conversion line may be a fourth wavelength line L4, the fourth impedance conversion line may be a fifth wavelength line L5, and the fifth impedance conversion line may be a sixth wavelength line L6. In the embodiment shown in FIG. 32 of this application, the second port and the third port of the hybrid coupler coupler1 may be respectively an isolation port and a coupling port that are relative to the fourth port of the hybrid coupler coupler1, and the first port of the hybrid coupler coupler1 is a through port relative to the hybrid coupler coupler1. Although not shown, in some other examples, the second port and the third port of the hybrid coupler coupler1 may be respectively a coupling port and a through port that are relative to the fourth port of the hybrid coupler coupler1, and the first port of the hybrid coupler coupler1 may be an isolation port relative to the fourth port of the hybrid coupler coupler1. In the embodiment shown in FIG. 32 of this application, through the hybrid coupler coupler1, an impedance conversion effect and a load pull effect are consistent with those in the embodiment shown in (b) in FIG. 6. Therefore, back-off conversion efficiency, full-load conversion efficiency, and quiescent power consumption that are equivalent to those in the embodiment in (b) in FIG. 6 are achieved while reducing area overheads caused by the fourth wavelength line L4 in the embodiment shown in (b) in FIG. 6.

In some examples, when the second port and the third port of the hybrid coupler coupler1 are grounded, or the second port and the third port of the hybrid coupler coupler1 are not used, and the second power amplification system 20B includes three branches, based on the architecture including two branches shown in FIG. 31, the second power amplification system 20B includes the first amplifier PA1, the second amplifier PA2, a third amplifier, the first impedance conversion line Z1, the second impedance conversion line Z2, the third impedance conversion line Z3, and a fourth impedance conversion line. The minimum operating power of the first amplifier PA1 is less than the minimum operating power of the second amplifier PA2. The output port of the first amplifier PA1 is coupled to the first port of the hybrid coupler coupler1 via the first impedance conversion line Z1. The output port of the second amplifier PA2 is coupled to the first port of the hybrid coupler coupler1 via the second impedance conversion line Z2 and the third impedance conversion line Z3 that are connected in series. An output port of the third amplifier is coupled to the fourth port of the hybrid coupler via the fourth impedance conversion line. A minimum operating power of the third amplifier is less than the minimum operating power of the first amplifier PA1. For example, as shown in FIG. 33, the first amplifier PA1 may be a first auxiliary amplifier A1, the second amplifier PA2 may be a second auxiliary amplifier A2, the third amplifier may be a first main amplifier M1, the first impedance conversion line may be a third wavelength line L3, the second impedance conversion line may be an eighth wavelength line L8, the third impedance conversion line may be a ninth wavelength line L9, and the fourth impedance conversion line may be a first wavelength line L1. In the embodiment shown in FIG. 33 of this application, the second port and the third port of the hybrid coupler coupler1 may be respectively an isolation port and a coupling port that are relative to the fourth port of the hybrid coupler coupler1, and the first port of the hybrid coupler coupler1 is a through port relative to the hybrid coupler coupler1. Although not shown, in some other examples, the second port and the third port of the hybrid coupler coupler1 may be respectively a coupling port and a through port that are relative to the fourth port of the hybrid coupler coupler1, and the first port of the hybrid coupler coupler1 may be an isolation port relative to the fourth port of the hybrid coupler coupler1. In the embodiment shown in FIG. 33 of this application, through the hybrid coupler coupler1, an impedance conversion effect and a load pull effect are consistent with those in the embodiment shown in (b) in FIG. 11. Therefore, back-off conversion efficiency, full-load conversion efficiency, and quiescent power consumption that are equivalent to those in the embodiment in (b) in FIG. 6 are achieved while reducing area overheads caused by the fourth wavelength line L4 in the embodiment shown in (b) in FIG. 11.

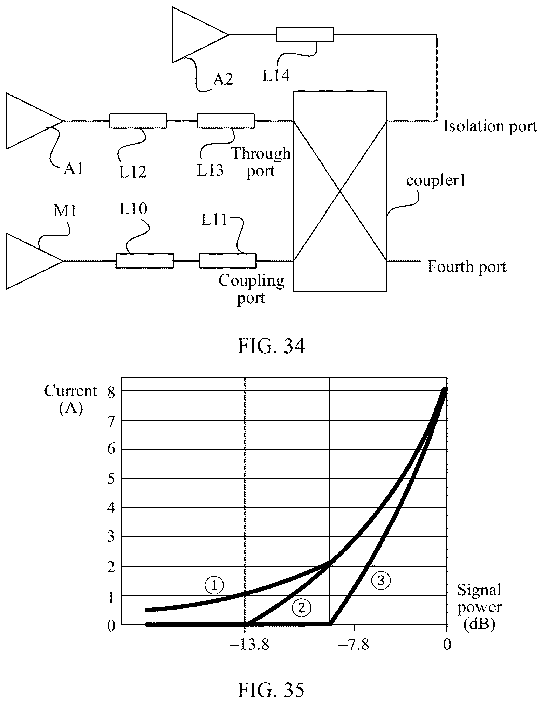

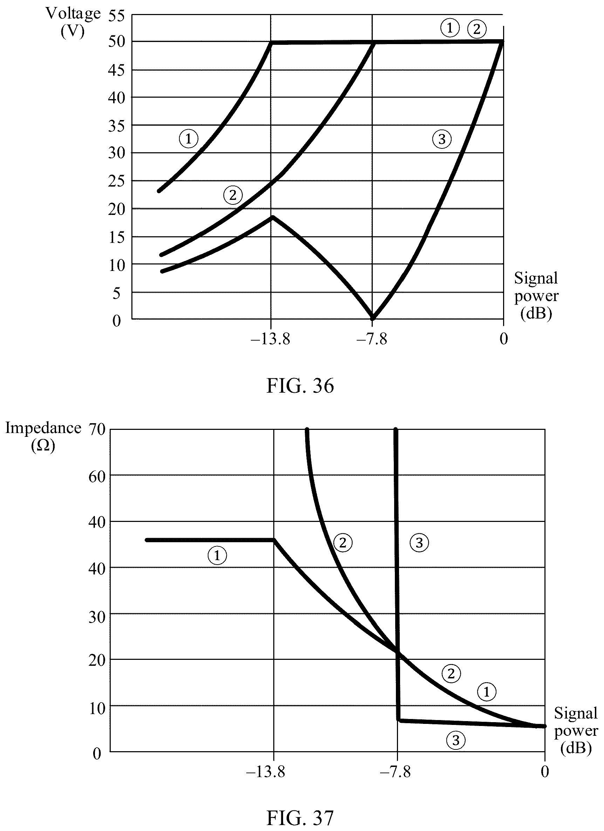

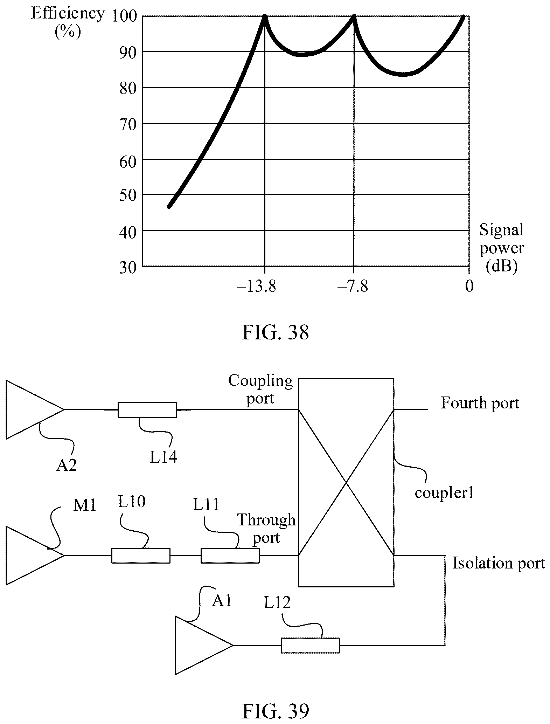

In some possible implementations, the first port, the second port, and the third port of the hybrid coupler couper1 each are coupled to at least one branch. For example, the second power amplification system 20B includes three branches. The second power amplification system 20B includes the first amplifier, the second amplifier, the third amplifier, the first impedance conversion line, and the second impedance conversion line. The output port of the first amplifier is coupled to the first port of the hybrid coupler via the first impedance conversion line. The output port of the second amplifier is coupled to the second port of the hybrid coupler via the second impedance conversion line. The output port of the third amplifier is coupled to the third port of the hybrid coupler. For example, the second power amplification system 20B further includes the third impedance conversion line, the fourth impedance conversion line, and the fifth impedance conversion line. The output port of the first amplifier is coupled to the first port of the hybrid coupler via the first impedance conversion line and the third impedance conversion line that are connected in series. The output port of the second amplifier is coupled to the second port of the hybrid coupler via the second impedance conversion line and the fourth impedance conversion line that are connected in series. The output port of the third amplifier is coupled to the third port of the hybrid coupler via the fifth impedance conversion line. For example, as shown in FIG. 34, the first amplifier may be a first main amplifier M1, the second amplifier may be a first auxiliary amplifier A1, the third amplifier may be a second auxiliary amplifier A2, the first impedance conversion line may be a tenth wavelength line L10, the second impedance conversion line may be a twelfth wavelength line L12, the third impedance conversion line may be an eleventh wavelength line L11, the fourth impedance conversion line may be a thirteenth wavelength line L13, and the fifth impedance conversion line may be a fourteenth wavelength line L14. The first port of the hybrid coupler coupler1 is a coupling port relative to the fourth port of the hybrid coupler coupler1, the second port of the hybrid coupler coupler1 is a through port relative to the fourth port of the hybrid coupler coupler1, and the third port of the hybrid coupler coupler1 is an isolation port relative to the fourth port of the hybrid coupler coupler1. FIG. 35, FIG. 36, FIG. 37, and FIG. 38 each are a diagram of a curve in which a circuit parameter in FIG. 34 varies with a signal power of an input radio frequency signal. FIG. 35 is a diagram of a curve in which a current of each branch of the second power amplification system 20B shown in FIG. 34 varies with a power of an input radio frequency signal. FIG. 36 is a diagram of a curve in which a voltage of each branch of the second power amplification system 20B shown in FIG. 34 varies with a power of an input radio frequency signal. FIG. 37 is a diagram of a curve in which an impedance load of each branch of the second power amplification system 20B shown in FIG. 34 varies with a power of an input radio frequency signal. FIG. 38 is a diagram of a curve in which conversion efficiency of the second power amplification system 20B shown in FIG. 34 varies with a power of an input radio frequency signal. In the figures, a line ① represents a branch in which the first main amplifier M1 is located, a line ② represents a branch in which the first auxiliary amplifier A1 is located, and a line ③ represents a branch in which the second auxiliary amplifier A2 is located. It can be learned that, for example, 0 dB is a maximum operating power point of the second power amplification system 20B. A power operating range below -13.8 dB is a low power operating range of the second power amplification system 20B, a power operating range ranging from -13.8 dB to -7.7 dB is a medium power range of the second power amplification system 20B, and a power operating range ranging from -7.7 dB to 0 dB is a high power range of the second power amplification system 20B. It can be learned from FIG. 35, FIG. 36, and FIG. 37 that, in the embodiment shown in FIG. 34, based on a load pull change completely different from that in the embodiments shown in FIG. 5, FIG. 6, FIG. 11, FIG. 16, FIG. 17, FIG. 18, FIG. 19, FIG. 20, FIG. 21, FIG. 22, FIG. 23, FIG. 24, FIG. 25, FIG. 26, FIG. 27, FIG. 28, FIG. 29, FIG. 30, FIG. 31, FIG. 32, and FIG. 33, a second radio frequency signal may be obtained by performing power combination on radio frequency signals output by a plurality of branches.

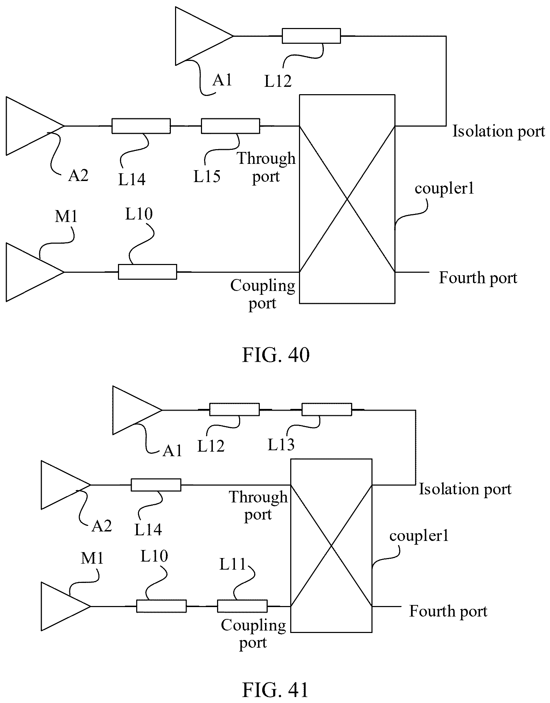

In some possible implementations, the first port, the second port, and the third port of the hybrid coupler coupler1 each are coupled to at least one branch. For example, the second power amplification system 20B includes three branches. The second power amplification system 20B includes the first amplifier, the second amplifier, the third amplifier, the first impedance conversion line, and the second impedance conversion line. The output port of the first amplifier is coupled to the first port of the hybrid coupler via the first impedance conversion line. The output port of the second amplifier is coupled to the second port of the hybrid coupler via the second impedance conversion line. The output port of the third amplifier is coupled to the third port of the hybrid coupler. For example, the second power amplification system 20B further includes the third impedance conversion line and the fourth impedance conversion line. The output port of the first amplifier is coupled to the first port of the hybrid coupler via the first impedance conversion line and the third impedance conversion line that are connected in series. The output port of the third amplifier is coupled to the third port of the hybrid coupler via the fourth impedance conversion line. For example, as shown in FIG. 39, the first amplifier may be a first main amplifier M1, the second amplifier may be a first auxiliary amplifier A1, the third amplifier may be a second auxiliary amplifier A2, the first impedance conversion line may be a tenth wavelength line L10, the second impedance conversion line may be a twelfth wavelength line L12, the third impedance conversion line may be an eleventh wavelength line L11, and the fourth impedance conversion line may be a fourteenth wavelength line L14. The first port of the hybrid coupler coupler1 is a through port relative to the fourth port of the hybrid coupler coupler1, the second port of the hybrid coupler coupler1 is an isolation port relative to the fourth port of the hybrid coupler coupler1, and the third port of the hybrid coupler coupler1 is a coupling port relative to the fourth port of the hybrid coupler coupler1. For example, as shown in FIG. 40, the first amplifier may be a second auxiliary amplifier A2, the second amplifier may be a first main amplifier M1, the third amplifier may be a first auxiliary amplifier A1, the first impedance conversion line may be a fourteenth wavelength line L14, the second impedance conversion line may be a tenth wavelength line L10, and the third impedance conversion line may be a fifteenth wavelength line L15. The first port of the hybrid coupler coupler1 is a through port relative to the fourth port of the hybrid coupler coupler1, the second port of the hybrid coupler coupler1 is a coupling port relative to the fourth port of the hybrid coupler coupler1, and the third port of the hybrid coupler coupler1 is an isolation port relative to the fourth port of the hybrid coupler coupler1.

In some possible implementations, the first port, the second port, and the third port of the hybrid coupler coupler1 each are coupled to at least one branch. For example, the second power amplification system 20B includes three branches. The second power amplification system 20B includes the first amplifier, the second amplifier, the third amplifier, the first impedance conversion line, and the second impedance conversion line. The output port of the first amplifier is coupled to the first port of the hybrid coupler via the first impedance conversion line. The output port of the second amplifier is coupled to the second port of the hybrid coupler via the second impedance conversion line. The output port of the third amplifier is coupled to the third port of the hybrid coupler. For example, the second power amplification system 20B further includes the third impedance conversion line, the fourth impedance conversion line, and the fifth impedance conversion line. The output port of the first amplifier is coupled to the first port of the hybrid coupler via the first impedance conversion line and the third impedance conversion line that are connected in series. The output port of the third amplifier is coupled to the third port of the hybrid coupler via the fourth impedance conversion line and the fifth impedance conversion line that are connected in series. For example, as shown in FIG. 41, the first amplifier may be a first main amplifier M1, the second amplifier may be a second auxiliary amplifier A2, the third amplifier may be a first auxiliary amplifier A1, the first impedance conversion line may be a tenth wavelength line L10, the second impedance conversion line may be a fourteenth wavelength line L14, the third impedance conversion line may be an eleventh wavelength line L11, the fourth impedance conversion line may be a twelfth wavelength line L12, and the fifth impedance conversion line may be a thirteenth wavelength line L13. The first port of the hybrid coupler coupler1 is a coupling port relative to the fourth port of the hybrid coupler coupler1, the second port of the hybrid coupler coupler1 is a through port relative to the fourth port of the hybrid coupler coupler1, and the third port of the hybrid coupler coupler1 is an isolation port relative to the fourth port of the hybrid coupler coupler1.

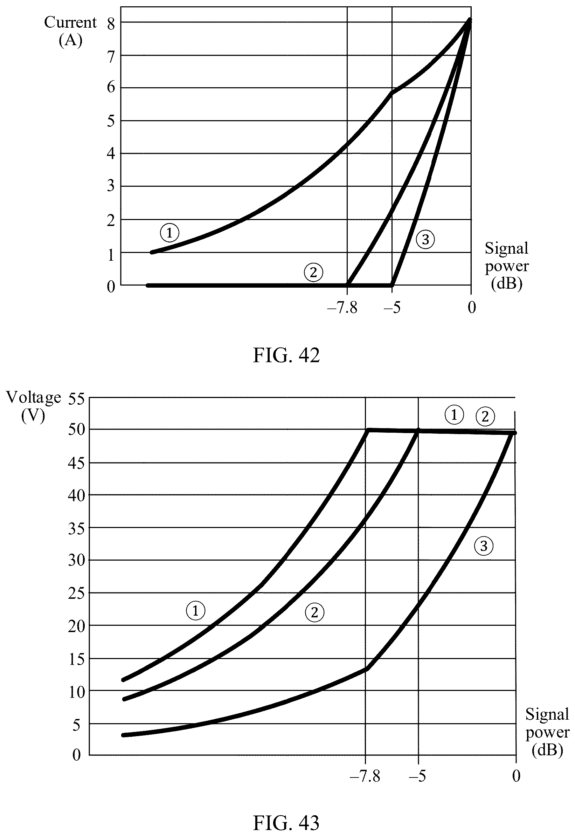

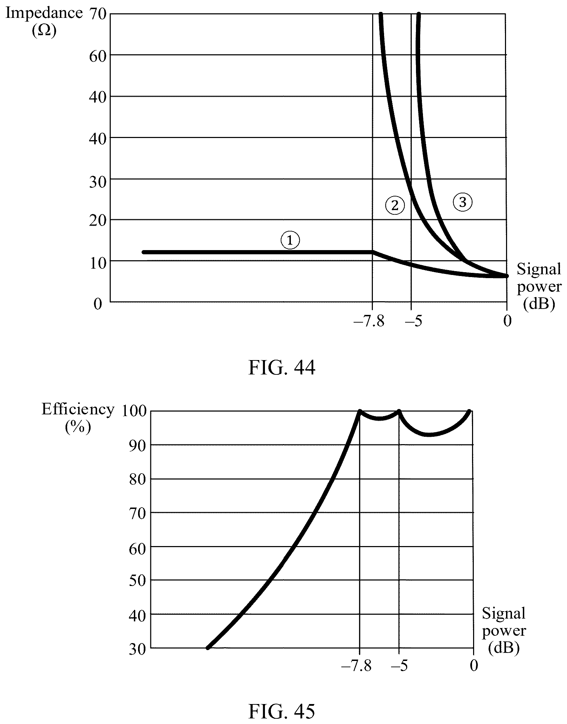

FIG. 42, FIG. 43, FIG. 44, and FIG. 45 each are a diagram of a curve in which a circuit parameter in the embodiments shown in FIG. 39, FIG. 40, and FIG. 41 varies with a signal power of an input radio frequency signal. FIG. 42 is a diagram of a curve in which a current of each branch of the second power amplification system 20B shown in FIG. 39, FIG. 40, and FIG. 41 varies with a power of an input radio frequency signal. FIG. 43 is a diagram of a curve in which a voltage of each branch of the second power amplification system 20B shown in FIG. 39, FIG. 40, and FIG. 41 varies with a power of an input radio frequency signal. FIG. 44 is a diagram of a curve in which an impedance load of each branch of the second power amplification system 20B shown in FIG. 39, FIG. 40, and FIG. 41 varies with a power of an input radio frequency signal. FIG. 45 is a diagram of a curve in which conversion efficiency of the second power amplification system 20B shown in FIG. 39, FIG. 40, and FIG. 41 varies with a power of an input radio frequency signal. In the figures, a line ① represents a branch in which the first main amplifier M1 is located, a line ② represents a branch in which the first auxiliary amplifier A1 is located, and a line ③ represents a branch in which the second auxiliary amplifier A2 is located. It can be learned that, for example, 0 dB is a maximum operating power point of the second power amplification system 20B. A power operating range below -7.7 dB is a low power operating range of the second power amplification system 20B, a power operating range ranging from -7.7 dB to -5 dB is a medium power range of the second power amplification system 20B, and a power operating range ranging from -5 dB to 0 dB is a high power range of the second power amplification system 20B. It can be learned from FIG. 42, FIG. 43, FIG. 44, and FIG. 45 that, in the embodiments shown in FIG. 39, FIG. 40, and FIG. 41, based on a load pull change different from that in the embodiments shown in FIG. 5, FIG. 6, FIG. 11, FIG. 16, FIG. 17, FIG. 18, FIG. 19, FIG. 20, FIG. 21, FIG. 22, FIG. 23, FIG. 24, FIG. 25, FIG. 26, FIG. 27, FIG. 28, FIG. 29, FIG. 30, FIG. 31, FIG. 32, FIG. 33, and FIG. 34, a second radio frequency signal may be obtained by performing power combination on radio frequency signals output by a plurality of branches.

In some possible implementations, in the embodiments shown in FIG. 16, FIG. 17, FIG. 18, FIG. 19, FIG. 20, FIG. 21, FIG. 22, FIG. 23, FIG. 24, FIG. 25, FIG. 26, FIG. 27, FIG. 28, FIG. 29, FIG. 30, FIG. 31, FIG. 32, FIG. 33, FIG. 34, FIG. 39, FIG. 40, and FIG. 41, the hybrid coupler coupler1 may be a coupler of a three-dimensional stacked structure. For example, the hybrid coupler coupler1 may be a coupler based on a waveguide suspended line process, or a suspended coupler based on a substrate integrated suspended line (Substrate Integrated Suspended Line, SISL) process. In embodiments of this application, a coupler of a three-dimensional stacked structure is used as the hybrid coupler coupler1. Compared with a conventional coupler, the coupler of a three-dimensional stacked structure is formed by using a plurality of stacked structures. This can reduce an area occupied by the coupler. When the hybrid coupler coupler1 is a suspended coupler, for example, a frequency band of an input radio frequency signal is 860 MHz, a length of one wavelength line is approximately 52 mm, and a length of one hybrid coupler coupler1 is 6 mm, so that area overheads of the second power amplification system 20B can be greatly reduced.

In some possible implementations, when the second power amplification system 20B is of a multi-branch structure with more than three branches, one or more structures in the embodiments shown in FIG. 16, FIG. 17, FIG. 18, FIG. 19, FIG. 20, FIG. 21, FIG. 22, FIG. 23, FIG. 24, FIG. 25, FIG. 26, FIG. 27, FIG. 28, FIG. 29, FIG. 30, FIG. 31, FIG. 32, FIG. 33, FIG. 34, FIG. 39, FIG. 40, and FIG. 41 may be included. In this case, one or more hybrid couplers coupler1 may be used to implement power combination.

For example, in the embodiments of FIG. 17, FIG. 18, FIG. 21, FIG. 23, FIG. 24, FIG. 25, FIG. 27, FIG. 28, FIG. 31, and FIG. 32, the second power amplification system 20B may further include a seventh wavelength line. A first port of the seventh wavelength line is coupled to the fourth port of the hybrid coupler coupler1, and a second port of the seventh wavelength line is used as an output port of the second power amplification system 20B. In embodiments of this application, output impedance matching of the second power amplification system 20B is implemented via the seventh wavelength line. In some other embodiments, the seventh wavelength line may not be disposed in the second power amplification system 20B, but the seventh wavelength line is disposed in a post-stage component of the second power amplification system 20B, or an impedance of the post-stage component of the second power amplification system 20B is adjusted.

For example, in the embodiments of FIG. 17, FIG. 19, FIG. 26, FIG. 29, and FIG. 30, the second power amplification system 20B may further include a second wavelength line. The fourth port of the hybrid coupler coupler1 is coupled to a first port of the second wavelength line. A second port of the second wavelength line is used as an output port of the second power amplification system 20B. In embodiments of this application, output impedance matching of the second power amplification system 20B is implemented via the second wavelength line. In some other embodiments, the second wavelength line may not be disposed in the second power amplification system 20B, but the second wavelength line is disposed in a post-stage component of the second power amplification system 20B, or an impedance of the post-stage component of the second power amplification system 20B is adjusted.

Embodiments of this application provide a power amplification system, a radio frequency transmission system, and a signal transmission apparatus. In the power amplification system, a hybrid coupler and a plurality of amplification branches are used to implement impedance conversion and load pull, to obtain a second radio frequency signal by performing power combination on radio frequency signals output by the plurality of amplification branches. For the plurality of amplification branches, a specific quantity of wavelength lines are needed as impedance conversion lines, to implement power combination on the plurality of radio frequency signals. However, the wavelength lines have high area overheads, restricting development of the power amplification system including the plurality of amplification branches. In embodiments of this application, the quantity of wavelength lines needed by the plurality of amplification branches can be reduced by disposing a hybrid coupler. In addition, as the quantity of amplification branches increases, more hybrid couplers may be disposed, and area overheads of the power amplification system are reduced to a greater extent. In addition, a larger quantity of wavelength lines that are equivalently reduced by each hybrid coupler indicates a higher reduction degree of the area overheads of the power amplification system. According to the solutions recorded in embodiments of this application, restrictions, due to area overheads of impedance conversion lines, on development of the power amplification system of an architecture including a plurality of amplification branches can be greatly reduced, so that the architecture including the plurality of amplification branches based on the impedance conversion lines can be better used in an application scenario with a large bandwidth, high back-off conversion efficiency, high full-load conversion efficiency, and low quiescent power consumption.

It may be clearly understood by a person skilled in the art that, for the purpose of convenient and brief description, for a detailed working process of the foregoing system, apparatus, and module, refer to a corresponding process in the foregoing method embodiments, and details are not described herein again.

In several embodiments provided in this application, it should be understood that the disclosed system and apparatus may be implemented in other manners. For example, the described apparatus embodiment is merely an example. For example, division into the modules is merely logical function division and may be other division in an actual implementation. For example, a plurality of modules or components may be combined or integrated into another device, or some features may be ignored or not performed. In addition, the displayed or discussed mutual couplings or direct couplings or communication connections may be implemented through some interfaces. The indirect couplings or communication connections between the devices or modules may be implemented in electronic, mechanical, or other forms.

The modules described as separate parts may or may not be physically separate, and parts displayed as modules may or may not be physical modules, that is, may be located in one device, or may be distributed on a plurality of devices. Some or all the modules may be selected based on actual needs to achieve the objectives of the solutions of embodiments.

In addition, functional modules in embodiments of this application may be integrated into one device, or each of the modules may exist alone physically, or two or more modules are integrated into one device.

The signal transmission apparatus in embodiments of this application may be a device configured to implement a wireless communication function, for example, a terminal or a chip that may be used in the terminal. The terminal may be a UE, an access terminal, a terminal unit, a terminal station, a mobile station, a remote station, a remote terminal, a mobile device, a wireless communication device, a terminal agent, a terminal apparatus, or the like in a 5G network, a 6G network, or a future evolved public land mobile network (public land mobile network, PLMN). The access terminal may be a cellular phone, a cordless phone, a session initiation protocol (session initiation protocol, SIP) phone, a wireless local loop (wireless local loop, WLL) station, a personal digital assistant (personal digital assistant, PDA), a handheld device having a wireless communication function, a computing device or another processing device connected to a wireless modem, a vehicle-mounted device, a wearable device, a virtual reality (virtual reality, VR) terminal device, an augmented reality (augmented reality, AR) terminal device, a wireless terminal in industrial control (industrial control), a wireless terminal in self-driving (self-driving), a wireless terminal in remote medical (remote medical), a wireless terminal in a smart grid (smart grid), a wireless terminal in transportation safety (transportation safety), a wireless terminal in a smart city (smart city), a wireless terminal in a smart home (smart home), or the like. Optionally, the electronic device and the transmission apparatus may be mobile or fixed.

In a possible implementation, the signal transmission apparatus in embodiments of this application may be a network device communicating with the terminal device. The network device may include a transmission reception point (transmission reception point, TRP), a base station, a remote radio unit (remote radio unit, RRU) or a baseband unit (baseband unit, BBU) (which may also be referred to as a digital unit (digital unit, DU)) of a split base station, a satellite, an uncrewed aerial vehicle, a broadband network service gateway (broadband network gateway, BNG), an aggregation switch, a non-3GPP access device, a relay station, an access point, or the like.

In addition, the base station may be a base transceiver station (base transceiver station, BTS) in a global system for mobile communications (global system for mobile communications, GSM) or code division multiple access (code division multiple access, CDMA) network, an NB (NodeB) in wideband code division multiple access (wideband code division multiple access, WCDMA), an eNB or eNodeB (evolutional NodeB) in LTE, a radio controller in a cloud radio access network (cloud radio access network, CRAN) scenario, a base station in a 5G communication system (for example, a next-generation NodeB (gNodeB, gNB)), a base station in a future evolved network, or the like. This is not specifically limited herein.

In addition, a communication architecture and a service scenario described in embodiments of this application are intended to describe the technical solutions in embodiments of this application more clearly, and do not constitute a limitation on the technical solutions provided in embodiments of this application. A person of ordinary skill in the art may learn that, with the evolution of the communication architecture and the emergence of new service scenarios, the technical solutions provided in embodiments of this application are also applicable to similar technical problems.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power amplification system, comprising a hybrid coupler, a first amplifier, a second amplifier, a first impedance conversion line, and a second impedance conversion line, wherein an output port of the first amplifier is coupled to the hybrid coupler via the first impedance conversion line, and an output port of the second amplifier is coupled to the hybrid coupler via the second impedance conversion line, wherein
the first amplifier and the second amplifier are configured to output radio frequency signals; and
the hybrid coupler is configured to:
perform impedance conversion with the first impedance conversion line and/or the second impedance conversion line; and
output a combined radio frequency signal from a fourth port of the hybrid coupler, wherein the combined radio frequency signal is obtained by combining the plurality of radio frequency signals.

2. The power amplification system according to claim 1, wherein the power amplification system further comprises a third amplifier; the output port of the first amplifier is coupled to a first port of the hybrid coupler via the first impedance conversion line; the output port of the second amplifier is coupled to a second port of the hybrid coupler via the second impedance conversion line; and an output port of the third amplifier is coupled to a third port of the hybrid coupler.

3. The power amplification system according to claim 1, wherein a third port of the hybrid coupler is grounded, and a minimum operating power of the first amplifier is less than a minimum operating power of the second amplifier.

4. The power amplification system according to claim 3, wherein the power amplification system further comprises a third amplifier; the output port of the first amplifier is coupled to a first port of the hybrid coupler via the first impedance conversion line; the output port of the second amplifier is coupled to a second port of the hybrid coupler via the second impedance conversion line; an output port of the third amplifier is coupled to the fourth port of the hybrid coupler; and the minimum operating power of the second amplifier is less than a minimum operating power of the third amplifier.

5. The power amplification system according to claim 3, wherein the power amplification system further comprises a third amplifier and a third impedance conversion line; the output port of the first amplifier is coupled to a first port of the hybrid coupler via the first impedance conversion line; the output port of the second amplifier is coupled to a second port of the hybrid coupler via the second impedance conversion line; an output port of the third amplifier is coupled to the fourth port of the hybrid coupler via the third impedance conversion line; and a minimum operating power of the third amplifier is less than the minimum operating power of the first amplifier.

6. The power amplification system according to claim 3, wherein the power amplification system further comprises a third amplifier, a third impedance conversion line, and a fourth impedance conversion line; the output port of the first amplifier is coupled to a first port of the hybrid coupler via the first impedance conversion line; the output port of the second amplifier is coupled to the first port of the hybrid coupler via the second impedance conversion line and the fourth impedance conversion line that are connected in series; an output port of the third amplifier is coupled to a second port of the hybrid coupler via the third impedance conversion line; and a minimum operating power of the third amplifier is less than the minimum operating power of the first amplifier.

7. The power amplification system according to claim 3, wherein the power amplification system further comprises a third amplifier; the output port of the first amplifier is coupled to a first port of the hybrid coupler via the first impedance conversion line; an output port of the third amplifier is coupled to the first port of the hybrid coupler; the output port of the second amplifier is coupled to a second port of the hybrid coupler via the second impedance conversion line; and a minimum operating power of the third amplifier is greater than the minimum operating power of the first amplifier and less than the minimum operating power of the second amplifier.

8. The power amplification system according to claim 3, wherein the power amplification system further comprises a third amplifier and a third impedance conversion line; the output port of the first amplifier is coupled to a first port of the hybrid coupler via the first impedance conversion line and the third impedance conversion line that are connected in series; an output port of the third amplifier is coupled to a first port of the third impedance conversion line, and is coupled to the first port of the hybrid coupler via a second port of the third impedance conversion line; the output port of the second amplifier is coupled to a second port of the hybrid coupler via the second impedance conversion line; and a minimum operating power of the third amplifier is greater than the minimum operating power of the first amplifier and less than the minimum operating power of the second amplifier.

9. The power amplification system according to claim 1, wherein a third port of the hybrid coupler is not used, and a minimum operating power of the first amplifier is less than a minimum operating power of the second amplifier.

10. The power amplification system according to claim 9, wherein the power amplification system further comprises a third amplifier and a third impedance conversion line; the output port of the first amplifier is coupled to a first port of the hybrid coupler via the first impedance conversion line; the output port of the second amplifier is coupled to a second port of the hybrid coupler via the second impedance conversion line; a first port of the third impedance conversion line is coupled to the fourth port of the hybrid coupler; an output port of the third amplifier is coupled to a second port of the third impedance conversion line; and the minimum operating power of the second amplifier is less than a minimum operating power of the third amplifier.

11. The power amplification system according to claim 9, wherein the power amplification system further comprises a third amplifier and a third impedance conversion line; the output port of the first amplifier is coupled to a first port of the hybrid coupler via the first impedance conversion line and the third impedance conversion line that are connected in series; the output port of the second amplifier is coupled to a second port of the hybrid coupler via the second impedance conversion line; an output port of the third amplifier is coupled to a first port of the third impedance conversion line, and is coupled to the first port of the hybrid coupler via a second port of the third impedance conversion line; and a minimum operating power of the third amplifier is greater than the minimum operating power of the first amplifier and less than the minimum operating power of the second amplifier.

12. The power amplification system according to claim 9, wherein the power amplification system further comprises a third amplifier, a third impedance conversion line, and a fourth impedance conversion line; the output port of the first amplifier is coupled to a first port of the hybrid coupler via the first impedance conversion line; the output port of the second amplifier is coupled to a second port of the hybrid coupler via the second impedance conversion line; a first port of the fourth impedance conversion line is coupled to the fourth port of the hybrid coupler; an output port of the third amplifier is coupled to a second port of the fourth impedance conversion line via the third impedance conversion line; and a minimum operating power of the third amplifier is less than the minimum operating power of the first amplifier.

13. The power amplification system according to claim 9, wherein the power amplification system further comprises a third amplifier and a third impedance conversion line; the output port of the first amplifier is coupled to a first port of the hybrid coupler via the first impedance conversion line; the output port of the second amplifier is coupled to the first port of the hybrid coupler via the second impedance conversion line and the third impedance conversion line that are connected in series; an output port of the third amplifier is coupled to a second port of the hybrid coupler; and the minimum operating power of the second amplifier is less than a minimum operating power of the third amplifier.

14. The power amplification system according to claim 9, wherein the power amplification system further comprises a third amplifier and a third impedance conversion line; the output port of the first amplifier is coupled to a first port of the hybrid coupler via the first impedance conversion line; the output port of the second amplifier is coupled to a second port of the hybrid coupler via the second impedance conversion line and the third impedance conversion line that are connected in series; an output port of the third amplifier is coupled to the fourth port of the hybrid coupler; and the minimum operating power of the second amplifier is less than a minimum operating power of the third amplifier.

15. The power amplification system according to claim 9, wherein the power amplification system further comprises a third amplifier, a third impedance conversion line, and a fourth impedance conversion line; the output port of the first amplifier is coupled to a first port of the hybrid coupler; the output port of the second amplifier is coupled to a second port of the hybrid coupler via the second impedance conversion line and the third impedance conversion line that are connected in series; an output port of the third amplifier is coupled to the fourth port of the hybrid coupler via the fourth impedance conversion line; and a minimum operating power of the third amplifier is less than the minimum operating power of the first amplifier.

16. The power amplification system according to claim 9, wherein the power amplification system further comprises a third amplifier, a third impedance conversion line, and a fourth impedance conversion line; the output port of the first amplifier is coupled to a first port of the hybrid coupler via the first impedance conversion line; the output port of the second amplifier is coupled to the first port of the hybrid coupler via the second impedance conversion line and the third impedance conversion line that are connected in series; an output port of the third amplifier is coupled to a second port of the hybrid coupler via the fourth impedance conversion line; and a minimum operating power of the third amplifier is less than the minimum operating power of the first amplifier.

17. The power amplification system according to claim 1, wherein a second port and a third port of the hybrid coupler are grounded, or a second port and a third port of the hybrid coupler are not used; the power amplification system further comprises a third impedance conversion line; a minimum operating power of the first amplifier is less than a minimum operating power of the second amplifier; the output port of the first amplifier is coupled to a first port of the hybrid coupler via the first impedance conversion line; and the output port of the second amplifier is coupled to the first port of the hybrid coupler via the second impedance conversion line and the third impedance conversion line that are connected in series.

18. The power amplification system according to claim 17, wherein the power amplification system further comprises a third amplifier; the fourth port of the hybrid coupler is coupled to an output port of the third amplifier; and the minimum operating power of the second amplifier is less than a minimum operating power of the third amplifier.

19. The power amplification system according to claim 17, wherein the power amplification system further comprises a third amplifier and a fourth impedance conversion line; an output port of the third amplifier is coupled to the fourth port of the hybrid coupler via the fourth impedance conversion line; and a minimum power of the third amplifier is less than the minimum operating power of the first amplifier.

20. The power amplification system according to any one of claims 1 to 19, wherein the hybrid coupler is a coupler based on a three-dimensional stacked structure.

21. A radio frequency transmission system, wherein the radio frequency transmission system comprises a radio frequency generation circuit and the power amplification system according to any one of claims 1 to 20; and an output port of the radio frequency generation circuit is coupled to an input port of the power amplification system.

22. A signal transmission apparatus, wherein the signal transmission apparatus comprises a baseband processing system and the radio frequency transmission system according to claim 21.
